# EUROPEAN PATENT APPLICATION

(11) **EP 4 700 397 A1**
(43) Date of publication of application: **25.02.2026**
(21) Application number: 24792586.0
(22) Date of filing: 11.04.2024
(51) Int. Cl.: G01R 27/02, G01R 27/08

(54) **IMPEDANCE MEASURING DEVICE AND IMPEDANCE MEASURING METHOD**

(30) Priority: 21.04.2023 JP 2023069707
(71) Applicant: Hioki E.E. Corporation, Ueda-shi, Nagano 386-1192 (JP)
(72) Inventor: KITAMURA, Naoya, Ueda-shi Nagano 386-1192 (JP); YOSHIHARA, Ryohei, Ueda-shi Nagano 386-1192 (JP); HANEDA, Kazuaki, Ueda-shi Nagano 386-1192 (JP)
(74) Representative: Novagraaf International SA
(86) International application number: PCT/JP2024/014609
(87) International publication number: WO 2024/219311

(57) **Abstract**

To individually and correctly calculate path impedances indicating connection states of source terminals and sense terminals with respect to a measurement target during four-terminal measurement. A detection current Ita is supplied to a first current path IR1 that includes a source terminal Hc, a measurement target DUT, and a source terminal Lc, a detection current Itb is supplied to a second current path IR2 that includes a sense terminal Hp, the measurement target DUT, and a sense terminal Lp, a voltage generated between the source terminal Hc and the sense terminal Hp and a voltage generated between the source terminal Lc and the sense terminal Lp during the supply of the detection currents Ita and Itb are detected as detection voltages, and each path impedance of each path between the source terminals Hc and Lc and the sense terminals Hp and Lp and one end and the other end of the measurement target DUT is calculated based on the detected detection voltages.

## Description

### TECHNICAL FIELD

The present invention relates to a four-wire impedance measuring device (for measuring an impedance using the four-terminal method) including a pair of source terminals (current supply terminals) and a pair of sense terminals (voltage detection terminals) connected to a measurement target, and to an impedance measuring method.

### BACKGROUND ART

For example, the four impedance measuring devices disclosed in the following PTL 1 are known as impedance measuring devices of the above-mentioned type. One of these impedance measuring devices includes a measurer and a processor, and a first ground in the power source system of the measurement signal source and a second ground in the power source system of the measurer are electrically separated. In this case, the measurer includes an inspection signal source that supplies an AC inspection current to a measurement target connected between the Hi-side sense terminal and the Lo-side sense terminal connected to the second ground, a first detector connected to the Hi-side source terminal and configured to detect, with reference to the second ground, a voltage generated at the Hi-side source terminal based on the AC measurement current flowing through a path extending from the Hi-side source terminal to the first ground through the Lo-side source terminal and output it as a first detection voltage, a second detector connected to the Lo-side source terminal and configured to detect, with reference to the second ground, a voltage generated at the Lo-side source terminal based on the AC measurement current and output it as a second detection voltage, a third detector connected to the Lo-side source terminal and configured to detect, with reference to the second ground, a voltage generated at the Lo-side source terminal based on the AC inspection current and output it as a third detection voltage, a fourth detector connected to the Hi-side sense terminal and configured to detect, with reference to the second ground, a voltage generated at the Hi-side sense terminal based on the AC measurement current and output it as a fourth detection voltage, and a fifth detector connected to the Hi-side sense terminal and configured to detect, with reference to the second ground, a voltage generated at the Hi-side sense terminal based on the AC inspection current and output it as a fifth detection voltage. In addition, based on the first detection voltage, second detection voltage, third detection voltage, fourth detection voltage, fifth detection voltage, AC measurement current and AC inspection current, the processor calculates the resistance value of the contact resistance RHC between the Hi-side source terminal and the measurement target, the resistance value of the contact resistance RLC between the Lo-side source terminal and the measurement target, the resistance value of the contact resistance RHP between the Hi-side sense terminal and the measurement target, and the resistance value of the contact resistance RLP between the Lo-side sense terminal and the measurement target.

In this case, the voltage value of the first detection voltage for a voltage generated at the source terminal Hc is a value proportional to the resistance value of a series composite resistance (Rx + RHC) of the internal resistance Rx of the measurement target and the contact resistance RHC. In addition, the voltage value of the second detection voltage for a voltage generated at the source terminal Lc is a value proportional to the resistance value of the contact resistance RLC. In addition, the voltage value of the third detection voltage for a voltage generated at the source terminal Lc is a value proportional to the resistance value of the contact resistance RLP. In addition, the voltage value of the fourth detection voltage for a voltage generated at the sense terminal Hp is a value proportional to the resistance value of the internal resistance Rx. In addition, the voltage value of the fifth detection voltage for a voltage generated at the sense terminal Hp is a value proportional to the resistance value of a series composite resistance (RHP + Rx + RLP) of the contact resistance RHP, the internal resistance Rx and the contact resistance RLP.

Accordingly, the processor calculates the resistance value of the series composite resistance (Rx + RHC) by dividing the voltage value of the first detection voltage by the known current value of the AC measurement current, calculates the resistance value of the contact resistance RLC by dividing the voltage value of the second detection voltage by the known current value of the AC measurement current, calculates the resistance value of the contact resistance RLP by dividing the voltage value of the third detection voltage by the known current value of the AC inspection current, calculates the resistance value of the internal resistance Rx by dividing the voltage value of the fourth detection voltage by the known current value of the AC measurement current, and calculates the resistance value of the series composite resistance (RHP + Rx + RLP) by dividing the voltage value of the fifth detection voltage by the known current value of the AC inspection current.

Next, the processor calculates the resistance value of the contact resistance RHC by subtracting the calculated resistance value of the internal resistance Rx from the calculated resistance value of the series composite resistance (Rx + RHC). In addition, the processor calculates the resistance value of the contact resistance RHP by subtracting the calculated resistance value of the internal resistance Rx and the resistance value of the contact resistance RLP from the calculated resistance value of series composite resistance (RHP + Rx + RLP). In this manner, the resistance values of the contact resistances RHC, RLC, RHP and RLP as the four path impedances are all calculated.

In this manner, with the inspection signal source and the detector for determining the resistance value of each contact resistance, the above-described impedance measuring device can individually measure the resistance values of the contact resistances (RHC, RLC, RHP, and RLP) between each of the Hi-side and Lo-side source terminals for signal supply and each of the Hi-side and Lo-side sense terminals for signal detection, and the corresponding electrode in the measurement target.

In addition, in the other three impedance measuring devices, as in the above-described impedance measuring device, five detectors are provided, and a processor can individually measure the resistance values of the contact resistances (RHC, RLC, RHP, and RLP) between each of the Hi-side and Lo-side source terminals for signal supply and each of the Hi-side and Lo-side sense terminals for signal detection, and the corresponding electrode in the measurement target by calculating the resistance value of each contact resistance between the Hi-side source terminal, Lo-side source terminal, Hi-side sense terminal and Lo-side sense terminal and the measurement target based on the first detection voltage, second detection voltage, third detection voltage, fourth detection voltage, fifth detection voltage, AC measurement current and AC inspection current detected by the five detectors.

### CITATION LIST

### PATENT LITERATURE

PTL 1: JP7154958A (pages 8 to 28 and FIGS. 1 to 4)

### SUMMARY OF INVENTION

### TECHNICAL PROBLEM

In the above-described impedance measuring device, however, in the final calculation of the resistance values of the contact resistances (RHC, RLC, RHP, RLP) from each detection voltage, the resistance values of the four contact resistances RHC, RLC, RHP and RLP of the detection target cannot be directly calculated based on each detection voltage, and subtraction processing is always required for the calculation of at least one contact resistance resistance value. That is, in these impedance measuring devices, in the calculation of at least one contact resistance resistance value, the resistance value of the internal resistance Rx of the measurement target and the resistance value of the contact resistance of objects other than the calculation target are calculated first, and then subtraction processing is performed utilizing the calculation results, thereby calculating the resistance value of the contact resistance of the calculation target. Specifically, for example, when calculating the resistance value of the contact resistance RHP as the detection target, the resistance value of the contact resistance RHP is calculated by subtracting the resistance value of another contact resistance RLP and the resistance value of the internal resistance Rx previously calculated by another operation, from the resistance value of the series composite resistance (RHP + Rx + RLP) that has been previously calculated. Accordingly, in these impedance measuring devices, subtraction processing is always required for the calculation of the resistance value of each contact resistance, and as such, computational errors in other calculation results are added and accumulated. As a result, in these impedance measuring devices, errors in calculating the resistance values of the respective contact resistances become large, and therefore improvement in this respect is required.

To solve the above-described problems, an object of the present invention is to provide an impedance measuring device and an impedance measuring method with which the path impedance (resistance value) indicating the connection state of each of the Hi-side source terminal, the Hi-side sense terminal, the Lo-side source terminal and the Lo-side sense terminal with respect to the measurement target during four-terminal measurement can be individually and correctly measured (calculated).

### SOLUTION TO PROBLEM

To solve the above-described object, an impedance measuring device according to the present invention includes: a measurement signal source configured to supply an AC measurement current to a measurement target, with one end connected to a Hi-side source terminal and a Hi-side sense terminal and the other end connected to a Lo-side source terminal and a Lo-side sense terminal, through each of the source terminals; a detection signal source configured to supply a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target; a detector configured to detect, through each of the sense terminals, an AC voltage generated between the one end of the measurement target and the other end of the measurement target due to supply of the AC measurement current, and detect, as a detection voltage, each voltage generated at each of the paths due to supply of the detection current; and a processor configured to calculate an impedance of the measurement target based on a voltage value of the AC voltage detected by the detector and a current value of the AC measurement current, and calculate each of the path impedances based on each of the detection voltages detected by the detector, in which the detection signal source is configured to supply a first detection current serving as the detection current to a first current path that includes the Hi-side source terminal, the measurement target, and one of the Lo-side source terminal and the Lo-side sense terminal, and supply a second detection current serving as the detection current to a second current path that includes the Hi-side sense terminal, the measurement target, and the other of the Lo-side source terminal and the Lo-side sense terminal, the detector detects, as the detection voltage, a voltage generated between the Hi-side source terminal and the Hi-side sense terminal and a voltage generated between the Lo-side source terminal and the Lo-side sense terminal during supply of the first detection current and the second detection current, and the processor calculates each of the path impedances based on each of the detection voltages detected by the detector.

To solve the above-described object, an impedance measuring method according to the present invention includes: supplying an AC measurement current to a measurement target, with one end connected to a Hi-side source terminal and a Hi-side sense terminal and the other end connected to a Lo-side source terminal and a Lo-side sense terminal, through each of the source terminals; detecting, through each of the sense terminals, an AC voltage generated between the one end of the measurement target and the other end of the measurement target due to supply of the AC measurement current; supplying a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target; detecting, as a detection voltage, each voltage generated at each of the paths due to supply of the detection current; and measuring an impedance of the measurement target based on a voltage value of the AC voltage detected and a current value of the AC measurement current and measuring each of the path impedances based on each of the detection voltages detected, in which a first detection current serving as the detection current is supplied to a first current path that includes the Hi-side source terminal, the measurement target, and one of the Lo-side source terminal and the Lo-side sense terminal, and a second detection current serving as the detection current is supplied to a second current path that includes the Hi-side sense terminal, the measurement target, and the other of the Lo-side source terminal and the Lo-side sense terminal, a voltage generated between the Hi-side source terminal and the Hi-side sense terminal and a voltage generated between the Lo-side source terminal and the Lo-side sense terminal during supply of the first detection current and the second detection current are detected as the detection voltage, and each of the path impedances is measured based on each of the detection voltages detected.

According to the impedance measuring device and the impedance measuring method, the first detection current is supplied to the first current path I that includes the Hi-side source terminal, the measurement target, and one of the Lo-side source terminal and the Lo-side sense terminal, the second detection current is supplied to the second current path that includes the Hi-side sense terminal, the measurement target, and the other of the Lo-side source terminal and the Lo-side sense terminal, the voltage generated between the Hi-side source terminal and the Hi-side sense terminal and the voltage generated between the Lo-side source terminal and the Lo-side sense terminal during the supply of the first detection current and the second detection current are detected as detection voltages, and the impedance of each path is measured based on the detected detection voltages, whereby each path impedance can be directly calculated without performing subtraction processing. Accordingly, according to the impedance measuring device and the impedance measuring method, the path impedance indicating the connection state of each of the Hi-side source terminal, the Hi-side sense terminal, the Lo-side source terminal and the Lo-side sense terminal with respect to the measurement target during four-terminal measurement can be individually and correctly measured (calculated).

To solve the above-described object, an impedance measuring device according to the present invention includes: a measurement signal source configured to supply an AC measurement current to a measurement target, with one end connected to a Hi-side source terminal and a Hi-side sense terminal and the other end connected to a Lo-side source terminal and a Lo-side sense terminal, through each of the source terminals; a detection signal source configured to supply a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target; a detector configured to detect, through each of the sense terminals, an AC voltage generated between the one end of the measurement target and the other end of the measurement target due to supply of the AC measurement current, and detect, as a detection voltage, each voltage generated at each of the paths due to supply of the detection current; and a processor configured to calculate an impedance of the measurement target based on a voltage value of the AC voltage detected by the detector and a current value of the AC measurement current, and calculate each of the path impedances based on each of the detection voltages detected by the detector, in which the detection signal source is configured to supply a first detection current serving as the detection current to a first current path that includes the Hi-side source terminal and the Hi-side sense terminal but does not include the measurement target, and supply a second detection current serving as the detection current to a second current path that includes the Lo-side source terminal and the Lo-side sense terminal but does not include the measurement target, the detector detects, as the detection voltage, a voltage generated between the Hi-side source terminal and one of the Lo-side source terminal and the Lo-side sense terminal and a voltage generated between the Hi-side sense terminal and the other of the Lo-side source terminal and the Lo-side sense terminal during supply of the first detection current and the second detection current, and the processor calculates each of the path impedances based on each of the detection voltages detected by the detector.

To solve the above-described object, an impedance measuring method according to the present invention includes: supplying an AC measurement current to a measurement target, with one end connected to a Hi-side source terminal and a Hi-side sense terminal and the other end connected to a Lo-side source terminal and a Lo-side sense terminal, through each of the source terminals; detecting, through each of the sense terminals, an AC voltage generated between the one end of the measurement target and the other end of the measurement target due to supply of the AC measurement current; supplying a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target; detecting, as a detection voltage, each voltage generated at each of the paths due to supply of the detection current; and measuring an impedance of the measurement target based on a voltage value of the AC voltage detected and a current value of the AC measurement current and measuring each of the path impedances based on each of the detection voltages detected, in which a first detection current serving as the detection current is supplied to a first current path that includes the Hi-side source terminal and the Hi-side sense terminal but does not include the measurement target, and a second detection current serving as the detection current is supplied to a second current path that includes the Lo-side source terminal and the Lo-side sense terminal but does not include the measurement target, a voltage generated between the Hi-side source terminal and one of the Lo-side source terminal and the Lo-side sense terminal and a voltage generated between the Hi-side sense terminal and the other of the Lo-side source terminal and the Lo-side sense terminal during supply of the first detection current and the second detection current are detected as the detection voltage, and each of the path impedances is measured based on each of the detection voltages detected.

According to the impedance measuring device and the impedance measuring method, the first detection current is supplied to the first current path that includes the Hi-side source terminal and the Hi-side sense terminal but does not include the measurement target, the second detection current is supplied to the second current path that includes the Lo-side source terminal and the Lo-side sense terminal but does not include the measurement target, the voltage generated between the Hi-side source terminal and one of the Lo-side source terminal and the Lo-side sense terminal and the voltage generated between the Hi-side sense terminal and the other of the Lo-side source terminal and the Lo-side sense terminal during the supply of the first detection current and the second detection current are detected as detection voltages, and the impedance of each path is measured based on the detected detection voltages, whereby each path impedance can be directly calculated without performing subtraction processing. Accordingly, according to the impedance measuring device and the impedance measuring method, the path impedance indicating the connection state of each of the Hi-side source terminal, the Hi-side sense terminal, the Lo-side source terminal and the Lo-side sense terminal with respect to the measurement target during four-terminal measurement can be individually and correctly measured (calculated).

In the impedance measuring device according to the present invention, the detection signal source supplies the first detection current and the second detection current of AC current, the detector includes a detection section configured to perform synchronous detection of each voltage generated between each of the terminals with a synchronization signal having the same frequency as a frequency of each of the detection currents, and detect the voltage as each of the detection voltages, and the processor calculates each of the path impedances based on each of the detection voltages detected by the detection section.

In this impedance measuring device, the detection signal source supplies the first detection current and the second detection current of AC current, and the synchronous detection circuit of the detector synchronously detects each voltage generated between each terminal with a synchronization signal having the same frequency as the frequency of the first detection current and the second detection current to detect it as each detection voltage, and the processor calculates each path impedance based on each detection voltage detected by the synchronous detection circuit, whereby each path impedance can be reliably and correctly calculated with a simple configuration.

In the impedance measuring device according to the present invention, the detection signal source is configured to supply the first detection current to a current path including the Hi-side source terminal, the measurement target and the Lo-side source terminal as the first current path, and supply the second detection current to a current path including the Hi-side sense terminal, the measurement target and the Lo-side sense terminal as the second current path, the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Hi-side sense terminal with a synchronization signal having the same frequency as a frequency of the first detection current, a third synchronous detection circuit configured to generate a third detection signal serving as the detection voltage by synchronously detecting the voltage generated between the Hi-side source terminal and the Hi-side sense terminal with a synchronization signal having the same frequency as a frequency of the second detection current, a fourth synchronous detection circuit configured to generate a fourth detection signal serving as the detection voltage by synchronously detecting the voltage generated between the Lo-side source terminal and the Lo-side sense terminal with the synchronization signal having the same frequency as the frequency of the first detection current, and a fifth synchronous detection circuit configured to generate a fifth detection signal serving as the detection voltage by synchronously detecting the voltage generated between the Lo-side source terminal and the Lo-side sense terminal with the synchronization signal having the same frequency as the frequency of the second detection current, and the processor calculates the impedance of the measurement target by using a voltage value of the first detection signal as the voltage value of the AC voltage detected by the detector, and calculates each of the path impedances based on the second detection signal, the third detection signal, the fourth detection signal and the fifth detection signal.

In the impedance measuring device according to the present invention, the detection signal source is configured to supply the first detection current to a current path including the Hi-side source terminal, the measurement target and the Lo-side sense terminal as the first current path, and supply the second detection current to a current path including the Hi-side sense terminal, the measurement target and the Lo-side source terminal as the second current path, the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Hi-side sense terminal with a synchronization signal having the same frequency as a frequency of the first detection current, a third synchronous detection circuit configured to generate a third detection signal serving as the detection voltage by synchronously detecting the voltage generated between the Hi-side source terminal and the Hi-side sense terminal with a synchronization signal having the same frequency as a frequency of the second detection current, a fourth synchronous detection circuit configured to generate a fourth detection signal serving as the detection voltage by synchronously detecting the voltage generated between the Lo-side source terminal and the Lo-side sense terminal with the synchronization signal having the same frequency as the frequency of the second detection current, and a fifth synchronous detection circuit configured to generate a fifth detection signal serving as the detection voltage by synchronously detecting the voltage generated between the Lo-side source terminal and the Lo-side sense terminal with the synchronization signal having the same frequency as the frequency of the first detection current, and the processor calculates the impedance of the measurement target by using a voltage value of the first detection signal as the voltage value of the AC voltage detected by the detector, and calculates each of the path impedances based on the second detection signal, the third detection signal, the fourth detection signal and the fifth detection signal.

In the impedance measuring device according to the present invention, the detector detects, as the detection voltage, a voltage generated between the Hi-side source terminal and the Lo-side source terminal, and a voltage generated between the Hi-side sense terminal and the Lo-side sense terminal during supply of the first detection current and the second detection current, the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Lo-side source terminal with a synchronization signal having the same frequency as a frequency of the first detection current, a third synchronous detection circuit configured to generate a third detection signal serving as the detection voltage by synchronously detecting the voltage generated between the Hi-side sense terminal and the Lo-side sense terminal with the synchronization signal having the same frequency as the frequency of the first detection current, a fourth synchronous detection circuit configured to generate a fourth detection signal serving as the detection voltage by synchronously detecting the voltage generated between the Hi-side source terminal and the Lo-side source terminal with a synchronization signal having the same frequency as a frequency of the second detection current, and a fifth synchronous detection circuit configured to generate a fifth detection signal serving as the detection voltage by synchronously detecting the voltage generated between the Hi-side sense terminal and the Lo-side sense terminal with the synchronization signal having the same frequency as the frequency of the second detection current, and the processor calculates the impedance of the measurement target by using a voltage value of the first detection signal as the voltage value of the AC voltage detected by the detector, and calculates each of the path impedances based on the second detection signal, the third detection signal, the fourth detection signal and the fifth detection signal.

In the impedance measuring device according to the present invention, the detector detects, as the detection voltage, a voltage generated between the Hi-side source terminal and the Lo-side sense terminal, and a voltage generated between the Hi-side sense terminal and the Lo-side source terminal during supply of the first detection current and the second detection current, the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Lo-side sense terminal with a synchronization signal having the same frequency as a frequency of the first detection current, a third synchronous detection circuit configured to generate a third detection signal serving as the detection voltage by synchronously detecting the voltage generated between the Hi-side sense terminal and the Lo-side source terminal with the synchronization signal having the same frequency as the frequency of the first detection current, a fourth synchronous detection circuit configured to generate a fourth detection signal serving as the detection voltage by synchronously detecting the voltage generated between the Hi-side sense terminal and the Lo-side source terminal with a synchronization signal having the same frequency as a frequency of the second detection current, and a fifth synchronous detection circuit configured to generate a fifth detection signal serving as the detection voltage by synchronously detecting the voltage generated between the Hi-side source terminal and the Lo-side sense terminal with the synchronization signal having the same frequency as the frequency of the second detection current, and the processor calculates the impedance of the measurement target by using a voltage value of the first detection signal as the voltage value of the AC voltage detected by the detector, and calculates each of the path impedances based on the second detection signal, the third detection signal, the fourth detection signal and the fifth detection signal.

In these impedance measuring devices, the detector is configured with the first synchronous detection circuit to the fifth synchronous detection circuit, the first detection signal voltage value is used as the voltage value of the AC voltage generated between one end of the measurement target and the other end when the processor supplies the AC measurement current to the measurement target, the measurement target impedance is calculated based on the voltage value of the AC voltage and the current value of the AC measurement current, and each path impedance is calculated based on the second detection signal, third detection signal, fourth detection signal and fifth detection signal, whereby each impedance can be simultaneously calculated in parallel, and as a result the impedance of the measurement target and each path impedance can be calculated in a short time.

In the impedance measuring device according to the present invention, the measurement signal source operates also as the detection signal source to supply the first detection current.

According to this impedance measuring device, the measurement signal source supplies the AC measurement current as the first detection current, whereby each path impedance can be directly calculated without performing subtraction processing with a simple configuration. Accordingly, according to this impedance measuring device, the path impedance indicating the connection state of each of the Hi-side source terminal, the Hi-side sense terminal, the Lo-side source terminal and the Lo-side sense terminal with respect to the measurement target during four-terminal measurement can be individually and correctly measured (calculated) with a simple configuration.

In the impedance measuring device according to the present invention, the frequency of the first detection current and the frequency of the second detection current are defined as values different from each other.

According to this impedance measuring device, the frequency of the first detection current and the frequency of the second detection current are defined as values different from each other, and thus each path impedance between each source terminal and each sense terminal, and the measurement target can be simultaneously calculated in parallel.

In the impedance measuring device according to the present invention, the frequency of the AC measurement current, the frequency of the first detection current, and the frequency of the second detection current are defined as values different from each other.

According to this impedance measuring device, the frequency of the AC measurement current, the frequency of the first detection current and the frequency of the second detection current are defined as values different from each other, and thus the impedance of the measurement target and each path impedance between each source terminal and each sense terminal, and the measurement target can be calculated in parallel. Accordingly, according to this impedance measuring device, the impedance of the measurement target and each path impedance can be calculated in the shortest time.

### ADVANTAGEOUS EFFECTS OF INVENTION

According to the impedance measuring device and the impedance measuring method according to the present invention, the path impedance indicating the connection state of each of the Hi-side source terminal, the Hi-side sense terminal, the Lo-side source terminal and the Lo-side sense terminal with respect to the measurement target during four-terminal measurement can be individually and correctly measured (calculated).

### BRIEF DESCRIPTION OF DRAWINGS

FIG. 1 is a configuration diagram illustrating a configuration of an impedance measuring device 1A.
FIG. 2 is a configuration diagram illustrating a configuration of an impedance measuring device 1Aa.
FIG. 3 is a configuration diagram illustrating a configuration of an impedance measuring device 1B.
FIG. 4 is a configuration diagram illustrating a configuration of an impedance measuring device 1C.
FIG. 5 is a configuration diagram illustrating a configuration of an impedance measuring device 1D.
FIG. 6 is a configuration diagram illustrating a configuration of an impedance measuring device 1Ab.
FIG. 7 is a configuration diagram illustrating a configuration of an impedance measuring device 1Da.

### DESCRIPTION OF EMBODIMENTS

An impedance measuring device and an impedance measuring method according to an embodiment are described below with reference to the accompanying drawings.

### Example 1

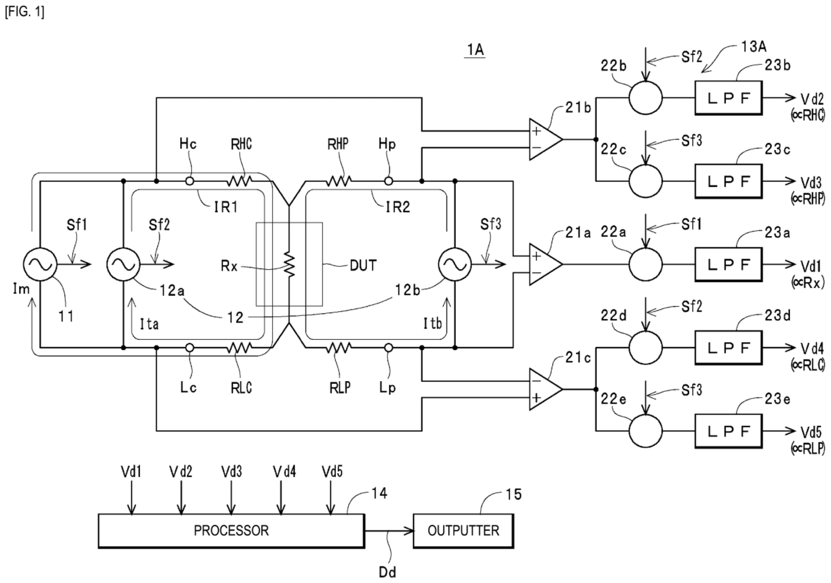

First, with reference to FIG. 1, a configuration of an impedance measuring device 1A serving as an impedance measuring device is described.

The impedance measuring device 1A includes a Hi (High) side source terminal Hc (a source terminal for supplying measurement signals composed of a connection terminal or a contact-type probe), a Lo (Low) side source terminal Lc (a source terminal for supplying measurement signals composed of a connection terminal or a contact-type probe), a Hi-side sense terminal Hp (a sense terminal for detecting signals composed of a connection terminal or a contact-type probe), a Lo-side sense terminal Lp (a sense terminal for detecting signals composed of a connection terminal or a contact-type probe), a measurement signal source 11, a detection signal source 12, a detector 13A, a processor 14 and an outputter 15.

In addition, the impedance measuring device 1A is configured to measure the impedance of a measurement target DUT (including only real number resistance value) in the state where the Hi-side source terminal Hc and the Hi-side sense terminal Hp are connected to one electrode of the measurement target DUT (through a measurement cable not illustrated in the drawing, for example), and the Lo-side source terminal Lc and the Lo-side sense terminal Lp are connected to the other electrode of the measurement target DUT (through a measurement cable not illustrated in the drawing, for example). In this example, as an example, the impedance measuring device 1A uses a battery as the measurement target DUT, and calculates (measures) the resistance value of the internal resistance (internal impedance) Rx of the measurement target DUT as an impedance in the state where the Hi-side source terminal Hc and the Hi-side sense terminal Hp are connected to the positive electrode of the battery serving as the measurement target DUT (one end of the measurement target), and the Lo-side source terminal Lc and the Lo-side sense terminal Lp are connected to the negative electrode of the battery (the other end of the measurement target).

The measurement signal source 11 supplies an AC measurement current Im to the measurement target DUT whose positive electrode (one end of the measurement target) and negative electrode (the other end of the measurement target) are connected between the Hi-side source terminal Hc and the Lo-side source terminal Lc. More specifically, the measurement signal source 11 supplies the AC measurement current Im to a path composed of the Hi-side source terminal Hc, the measurement target DUT, and the Lo-side source terminal Lc. In this case, the measurement signal source 11 generates and outputs a sinusoidal AC current defined with a constant (known) amplitude and a constant frequency f1 as the AC measurement current Im. In addition, the measurement signal source 11 outputs a synchronization signal Sf1 having the frequency f1 and synchronized with the AC measurement current Im.

The detection signal source 12 includes a first detection signal generation circuit 12a and a second detection signal generation circuit 12b, and supplies a detection current for detecting each path impedance of each path between the source terminals Hc and Lc and the sense terminals Hp and Lp and the positive electrode and negative electrode of the measurement target DUT. The first detection signal generation circuit 12a is connected between the Hi-side source terminal Hc and the Lo-side source terminal Lc, generates a detection current Ita serving as the first detection current for detecting a path impedance composed of contact resistance and wiring resistance in a first current path IR1 that includes the Hi-side source terminal Hc, the measurement target DUT, and the Lo-side source terminal Lc as one of the Lo-side source terminal Lc and the Lo-side sense terminal Lp (an impedance composed of contact resistance and wiring resistance in the path between the Hi-side source terminal Hc and the positive electrode of the measurement target DUT (one end of the measurement target), and an impedance composed of contact resistance and wiring resistance in the path between the Lo-side source terminal Lc and the negative electrode of the measurement target DUT (the other end of the measurement target)), and supplies it to the first current path IR1. In this case, the first detection signal generation circuit 12a generates and outputs a sinusoidal AC current defined with a constant (known) amplitude and a constant frequency f2 having a frequency value different from the frequency f1 as the detection current Ita. In addition, the first detection signal generation circuit 12a outputs a synchronization signal Sf2 having the same frequency f2 and synchronized with the detection current Ita.

The second detection signal generation circuit 12b is connected between the Hi-side sense terminal Hp and the Lo-side sense terminal Lp, generates a detection current Itb serving as the second detection current for detecting a path impedance composed of contact resistance and wiring resistance in a second current path IR2 that includes the Hi-side sense terminal Hp, the measurement target DUT, and the Lo-side sense terminal Lp as the other of the Lo-side source terminal Lc and the Lo-side sense terminal Lp (an impedance composed of contact resistance and wiring resistance in the path between the Hi-side sense terminal Hp and the positive electrode of the measurement target DUT (one end of the measurement target), and an impedance composed of contact resistance and wiring resistance in the path between the Lo-side sense terminal Lp and the negative electrode of the measurement target DUT (the other end of the measurement target)), and supplies it to the second current path IR2. In this case, the second detection signal generation circuit 12b generates and outputs a sinusoidal AC current defined with a constant (known) amplitude and a constant frequency f3 having a frequency value different from the frequencies f1 and f2 as the detection current Itb. In addition, the second detection signal generation circuit 12b outputs a synchronization signal Sf3 having the same frequency f3 and synchronized with the detection current Itb.

The detector 13A includes amplification circuits 21a to 21c, synchronous detection circuits 22a to 22e, and low-pass filters (hereinafter referred to as "LPF" in each drawing) 23a to 23e, detects, through the Hi-side sense terminal Hp and the Lo-side sense terminal Lp, an AC voltage generated between the positive electrode and negative electrode of the measurement target DUT due to the supply of the AC measurement current Im, and detects each voltage generated in each of the above-described paths due to the supply of the detection currents Ita and Itb as a detection voltage. Here, the synchronous detection circuits 22a to 22e and the low-pass filters 23a to 23e make up a detection section.

In this case, as described later, the processor 14 calculates a resistance value VRx of the internal resistance Rx of the measurement target DUT based on the AC voltage generated between the positive electrode and negative electrode of the measurement target DUT detected by the detector 13A, and calculates a resistance value VRHC of a contact resistance RHC between the Hi-side source terminal Hc and the positive electrode of the measurement target DUT, a resistance value VRLC of a contact resistance RLC between the Lo-side source terminal Lc and the negative electrode of the measurement target DUT, a resistance value VRHP of a contact resistance RHP between the Hi-side sense terminal Hp and the positive electrode of the measurement target DUT, and a resistance value VRLP of a contact resistance RLP between the Lo-side sense terminal Lp and the negative electrode of the measurement target DUT, as path impedances based on each voltage generated in each of the above-described paths detected by the detector 13A. Here, as described above, each of the contact resistances RHC, RLC, RHP and RLP may be a concept of a path impedance of contact resistance and wiring resistance (the resistance of the measurement cable) in a region from the corresponding terminal of the terminals Hc, Lc, Hp and Lp to the corresponding electrode of the positive electrode and negative electrode of the measurement target DUT, or a concept of the contact resistance of each of the terminals Hc, Lc, Hp and Lp only.

The amplification circuit 21a (first amplification circuit) is configured as a differential amplifier circuit using a computation amplifier, with a non-inverting input terminal connected to the Hi-side sense terminal Hp and an inverting input terminal connected to the Lo-side sense terminal Lp, and outputs, with a defined gain, the voltage difference between the voltage of the sense terminal Lp and the voltage of the sense terminal Hp. Accordingly, the amplification circuit 21a outputs an AC signal whose voltage value varies in accordance with the voltage value (for example, amplitude) of the AC voltage generated across the internal resistance Rx when the AC measurement current Im flows through the internal resistance Rx. The amplification circuit 21b (second amplification circuit) is configured as a differential amplifier circuit using a computation amplifier, with a non-inverting input terminal connected to the Hi-side source terminal Hc and an inverting input terminal connected to the Hi-side sense terminal Hp, and outputs, with a defined gain, the voltage difference between the voltage of the sense terminal Hp and the voltage of the source terminal Hc. Accordingly, the amplification circuit 21b outputs an AC signal whose voltage value varies in accordance with the voltage value (for example, amplitude) of a voltage that is the sum of the voltage generated across the contact resistance RHC when the detection current Ita flows through the contact resistance RHC and the voltage generated across the contact resistance RHP when the detection current Itb flows through the contact resistance RHP. The amplification circuit 21c (third amplification circuit) is configured as a differential amplifier circuit using a computation amplifier, with a non-inverting input terminal connected to the Lo-side source terminal Lc and an inverting input terminal connected to the Lo-side sense terminal Lp, and outputs, with a defined gain, the voltage difference between the voltage of the sense terminal Lp and the voltage of the source terminal Lc. Accordingly, the amplification circuit 21c outputs an AC signal whose voltage value varies in accordance with the voltage value (for example, amplitude) of a voltage that is the sum of the voltage generated across the contact resistance RLC when the detection current Ita flows through the contact resistance RLC and the voltage generated across the contact resistance RLP when the detection current Itb flows through the contact resistance RLP.

The synchronous detection circuit 22a is, as an example, configured as a first synchronous detection circuit together with the low-pass filter 23a using a multiplier, and by multiplying a signal output from the amplification circuit 21a with the synchronization signal Sf1 output from the measurement signal source 11 (in other words, by synchronously detecting a signal output from the amplification circuit 21a with this synchronization signal Sf1), outputs a DC signal whose voltage value varies in accordance with the voltage value (for example, amplitude) of the AC voltage generated across the internal resistance Rx of the measurement target DUT when the AC measurement current Im flows through the measurement target DUT. In addition, the low-pass filter 23a is configured as a low-pass filter, receives a DC signal with a superimposed AC component output from the synchronous detection circuit 22a, and performs smoothing by removing the AC component, thereby outputting a first detection voltage Vd1 as the first detection signal.

In this case, the first detection voltage Vd1 is a voltage that is obtained based on the voltage generated between the sense terminal Lp and the sense terminal Hp due to the AC measurement current Im flowing through the measurement target DUT, and therefore its voltage value is a value (∝VRx) proportional to the resistance value VRx of the internal resistance Rx. In this manner, as described later, by dividing the voltage value of the first detection voltage Vd1 by the known current value of the AC measurement current Im, the resistance value VRx of the internal resistance Rx of the measurement target DUT is directly calculated.

A synchronous detection circuit 22b is, as an example, configured as a second synchronous detection circuit together with a low-pass filter 23b using a multiplier, and by multiplying a signal output from the amplification circuit 21b with the synchronization signal Sf2 output from the first detection signal generation circuit 12a (in other words, by synchronously detecting a signal output from the amplification circuit 21b with this synchronization signal Sf2), outputs a DC signal whose voltage value varies in accordance with the voltage value (for example, amplitude) of the AC voltage generated across the contact resistance RHC when the detection current Ita flows through the contact resistance RHC. In addition, the low-pass filter 23b is configured as a low-pass filter, receives a DC signal with a superimposed AC component output from the synchronous detection circuit 22b, and performs smoothing by removing the AC component, thereby outputting a second detection voltage Vd2 as the second detection signal.

In this case, the second detection voltage Vd2 is a voltage that is obtained based on the voltage generated between the sense terminal Hp and the source terminal Hc due to the detection current Ita flowing through the contact resistance RHC, and therefore its voltage value is a value (∝VRHC) proportional to the resistance value VRHC of the contact resistance RHC. In this manner, as described later, by dividing the voltage value of the second detection voltage Vd2 by the known current value of the detection current Ita, the resistance value VRHC of the contact resistance RHC is directly calculated.

The synchronous detection circuit 22c is, as an example, configured as a third synchronous detection circuit together with a low-pass filter 23c using a multiplier, and by multiplying a signal output from the amplification circuit 21b with the synchronization signal Sf3 output from the second detection signal generation circuit 12b (in other words, by synchronously detecting a signal output from the amplification circuit 21b with this synchronization signal Sf3), outputs a DC signal whose voltage value varies in accordance with the voltage value (for example, amplitude) of the AC voltage generated across the contact resistance RHP when the detection current Itb flows through the contact resistance RHP. In addition, the low-pass filter 23c is configured as a low-pass filter, receives a DC signal with a superimposed AC component output from the synchronous detection circuit 22c, and performs smoothing by removing the AC component, thereby outputting a third detection voltage Vd3 as the third detection signal.

In this case, the third detection voltage Vd3 is a voltage that is obtained based on the voltage generated between the sense terminal Hp and the source terminal Hc due to the detection current Itb flowing through the contact resistance RHP, and therefore its voltage value is a value (∝VRHP) proportional to the resistance value VRHP of the contact resistance RHP. In this manner, as described later, by dividing the voltage value of the third detection voltage Vd3 by the known current value of the detection current Itb, the resistance value VRHP of the contact resistance RHP is directly calculated.

A synchronous detection circuit 22d is, as an example, configured as a fourth synchronous detection circuit together with a low-pass filter 23d using a multiplier, and by multiplying a signal output from the amplification circuit 21c with the synchronization signal Sf2 output from the first detection signal generation circuit 12a (in other words, by synchronously detecting a signal output from the amplification circuit 21c with this synchronization signal Sf2), outputs a DC signal whose voltage value varies in accordance with the voltage value (for example, amplitude) of the AC voltage generated across the contact resistance RLC when the detection current Ita flows through the contact resistance RLC. In addition, the low-pass filter 23d is configured as a low-pass filter, receives a DC signal with a superimposed AC component output from the synchronous detection circuit 22d, and performs smoothing by removing the AC component, thereby outputting a fourth detection voltage Vd4 as the fourth detection signal.

In this case, the fourth detection voltage Vd4 is a voltage that is obtained based on the voltage generated between the sense terminal Lp and the source terminal Lc due to the detection current Ita flowing through the contact resistance RLC, and therefore its voltage value is a value (∝VRLC) proportional to the resistance value VRLC of the contact resistance RLC. In this manner, as described later, by dividing the voltage value of the fourth detection voltage Vd4 by the known current value of the detection current Ita, the resistance value VRLC of the contact resistance RLC is directly calculated.

The synchronous detection circuit 22e is, as an example, configured as a fifth synchronous detection circuit together with the low-pass filter 23e using a multiplier, and by multiplying a signal output from the amplification circuit 21c with the synchronization signal Sf3 output from the second detection signal generation circuit 12b (in other words, by synchronously detecting a signal output from the amplification circuit 21c with this synchronization signal Sf3), outputs a DC signal whose voltage value varies in accordance with the voltage value (for example, amplitude) of the AC voltage generated across the contact resistance RLP when the detection current Itb flows through the contact resistance RLP. In addition, the low-pass filter 23e is configured as a low-pass filter, receives a DC signal with a superimposed AC component output from the synchronous detection circuit 22e, and performs smoothing by removing the AC component, thereby outputting a fifth detection voltage Vd5 as the fifth detection signal.

In this case, the fifth detection voltage Vd5 is a voltage that is obtained based on the voltage generated between the sense terminal Lp and the source terminal Lc due to the detection current Itb flowing through the contact resistance RLP, and therefore its voltage value is a value (∝VRLP) proportional to the resistance value VRLP of the contact resistance RLP. In this manner, as described later, by dividing the voltage value of the fifth detection voltage Vd5 by the known current value of the detection current Itb, the resistance value VRLP of the contact resistance RLP is directly calculated.

The processor 14 includes, as an example, an A/D convertor, a CPU and a memory (which are not illustrated in the drawing), and executes impedance calculation processing of calculating the impedance of the internal resistance Rx of the measurement target DUT (in this example, the resistance value VRx) and path impedance calculation processing of calculating a path impedance (the impedance of each of the contact resistances RHC, RLC, RHP and RLP (in this example, each of the resistance values VRx, VRHC, VRLC, VRHP and VRLP)). In the impedance calculation processing, the processor 14 receives the first detection voltage Vd1 and calculates its voltage value, and, based on this voltage value and the known current value of the AC measurement current Im, calculates (measures) the resistance value VRx of the internal resistance Rx of the measurement target DUT. In this case, the processor 14 may calculate the resistance value VRx of the internal resistance Rx as a complex impedance, or may calculate a real resistance value. Hereinafter, the calculation of impedance may refer either to the calculation of the complex impedance or to the calculation of the real resistance value.

In addition, in the path impedance calculation processing, the processor 14 receives the second detection voltage Vd2, the third detection voltage Vd3, the fourth detection voltage Vd4 and the fifth detection voltage Vd5 and calculates their voltage values, and, based on their voltage values and the known current values of the detection currents Ita and Itb, calculates (measures) the impedance of each of the contact resistances RHC, RLC, RHP and RLP (the resistance value VRHC of the contact resistance RHC, the resistance value VRLC of the contact resistance RLC, the resistance value VRHP of the contact resistance RHP and the resistance value VRLP of the contact resistance RLP). In addition, the processor 14 executes output processing of causing the outputter 15 to output data Dd in which the calculated internal resistance Rx and resistance values VRx, VRHC, VRLC, VRHP and VRLP of the contact resistances RHC, RLC, RHP and RLP are described.

As an example, the outputter 15 is composed of a display device, and displays (outputs) the internal resistance Rx and the resistance values VRx, VRHC, VRLC, VRHP and VRLP of the contact resistances RHC, RLC, RHP and RLP on the screen based on the data Dd output from the processor 14. Note that the outputter 15 may be composed of various interface circuits instead of the display device. In the case where the outputter 15 is composed of an external interface circuit, it outputs the internal resistance Rx and the resistance values VRx, VRHC, VRLC, VRHP and VRLP of the contact resistances RHC, RLC, RHP and RLP to an external apparatus connected by the transmission path through the external interface circuit. In the case where the outputter 15 is composed of a medium interface circuit, it stores the internal resistance Rx and the resistance values VRx, VRHC, VRLC, VRHP and VRLP of the contact resistances RHC, RLC, RHP and RLP in a storage medium connected to the medium interface circuit.

Next, an operation of the impedance measuring device 1A is described with reference to the accompanying drawings. Note that the impedance measuring device 1A is connected to the measurement target DUT (battery) at the source terminals Hc and Lc and the sense terminals Hp and Lp through four measurement cables not illustrated in the drawing.

In the impedance measuring device 1A, the measurement signal source 11 supplies the AC measurement current Im having the frequency f1 to the measurement target DUT connected between the source terminal Hc and the sense terminal Hp and the source terminal Lc and the sense terminal Lp. In addition, the first detection signal generation circuit 12a supplies the detection current Ita having the frequency f2 to the first current path IR1, and the second detection signal generation circuit 12b supplies the detection current Itb having the frequency f3 to the second current path IR2.

In this state, in the detector 13A, the amplification circuit 21a outputs, with a defined gain, the voltage difference between the voltage of the sense terminal Lp and the voltage of the sense terminal Hp to the synchronous detection circuit 22a. At this time, by multiplying the AC signal output from the amplification circuit 21a with the synchronization signal Sf1 output from the measurement signal source 11, the synchronous detection circuit 22a outputs a DC signal whose voltage value varies in accordance with the voltage value of the AC voltage generated across the internal resistance Rx of the measurement target DUT when the AC measurement current Im flows through the measurement target DUT and in which an AC component is superimposed. Next, the low-pass filter 23a receives a DC signal with a superimposed AC component output from the synchronous detection circuit 22a, and performs smoothing by removing the AC component, thereby generating and outputting the first detection voltage Vd1.

In addition, the amplification circuit 21b outputs, with a defined gain, the voltage difference between the voltage of the sense terminal Hp and the voltage of the source terminal Hc to the synchronous detection circuits 22b and 22c. At this time, by multiplying the AC signal output from the amplification circuit 21b with the synchronization signal Sf2 output from the first detection signal generation circuit 12a, the synchronous detection circuit 22b outputs a DC signal whose voltage value varies in accordance with the voltage value of the AC voltage generated across the contact resistance RHC when the detection current Ita flows through the contact resistance RHC and in which an AC component is superimposed. Next, the low-pass filter 23b receives a DC signal with a superimposed AC component output from the synchronous detection circuit 22b, and performs smoothing by removing the AC component, thereby generating and outputting the second detection voltage Vd2. In addition, by multiplying the AC signal output from the amplification circuit 21b with the synchronization signal Sf3 output from the second detection signal generation circuit 12b, the synchronous detection circuit 22c outputs a DC signal whose voltage value varies in accordance with the voltage value of the AC voltage generated across the contact resistance RHP when the detection current Itb flows through the contact resistance RHP and in which an AC component is superimposed. Next, the low-pass filter 23c receives a DC signal with a superimposed AC component output from the synchronous detection circuit 22c, and performs smoothing by removing the AC component, thereby generating and outputting the third detection voltage Vd3.

In addition, the amplification circuit 21c outputs, with a defined gain, the voltage difference between the voltage of the sense terminal Lp and the voltage of the source terminal Lc to the synchronous detection circuits 22d and 22e. At this time, by multiplying the AC signal output from the amplification circuit 21c with the synchronization signal Sf2 output from the first detection signal generation circuit 12a, the synchronous detection circuit 22d outputs a DC signal whose voltage value varies in accordance with the voltage value of the AC voltage generated across the contact resistance RLC when the detection current Ita flows through the contact resistance RLC and in which an AC component is superimposed. Next, the low-pass filter 23d receives a DC signal with a superimposed AC component output from the synchronous detection circuit 22d, and performs smoothing by removing the AC component, thereby generating and outputting the fourth detection voltage Vd4. In addition, by multiplying the AC signal output from the amplification circuit 21c with the synchronization signal Sf3 output from the second detection signal generation circuit 12b, the synchronous detection circuit 22e outputs a DC signal whose voltage value varies in accordance with the voltage value of the AC voltage generated across the contact resistance RLP when the detection current Itb flows through the contact resistance RLP and in which an AC component is superimposed. Next, the low-pass filter 23e receives a DC signal with a superimposed AC component output from the synchronous detection circuit 22e, and performs smoothing by removing the AC component, thereby generating and outputting the fifth detection voltage Vd5.

The processor 14 executes the impedance calculation processing and the path impedance calculation processing based on the detection voltages Vd1, Vd2, Vd3, Vd4 and Vd5 output from the low-pass filters 23a to 23e. In these calculation processes, first, the processor 14 performs A/D conversion of the detection voltages Vd1, Vd2, Vd3, Vd4 and Vd5 into voltage data representing voltage values of the detection voltages Vd1, Vd2, Vd3, Vd4 and Vd5. Next, the processor 14 calculates the voltage values of the detection voltages Vd1, Vd2, Vd3, Vd4 and Vd5 based on the voltage data about the detection voltages Vd1, Vd2, Vd3, Vd4 and Vd5.

In this case, as described above, the voltage value of the first detection voltage Vd1 for an AC voltage generated between the sense terminal Lp and the sense terminal Hp due to the supply of the AC measurement current Im is a value proportional to the resistance value VRx of the internal resistance Rx. In addition, the voltage value of the second detection voltage Vd2 for a voltage generated between the sense terminal Hp and the source terminal Hc due to the supply of the detection current Ita is a value proportional to the resistance value VRHC of the contact resistance RHC. In addition, the voltage value of the third detection voltage Vd3 for a voltage generated between the sense terminal Hp and the source terminal Hc due to the supply of the detection current Itb is a value proportional to the resistance value VRHP of the contact resistance RHP. In addition, the voltage value of the fourth detection voltage Vd4 for a voltage generated between the sense terminal Lp and the source terminal Lc due to the supply of the detection current Ita is a value proportional to the resistance value VRLC of the contact resistance RLC. In addition, the voltage value of the fifth detection voltage Vd5 for a voltage generated between the sense terminal Lp and the source terminal Lc due to the supply of the detection current Itb is a value proportional to the resistance value VRLP of the contact resistance RLP.

Next, the processor 14 calculates the resistance value VRx of the internal resistance Rx by dividing the voltage value of the first detection voltage Vd1 by the known current value of the AC measurement current Im, calculates the resistance value VRHC of the contact resistance RHC by dividing the voltage value of the second detection voltage Vd2 by the known current value of the detection current Ita, calculates the resistance value VRHP of the contact resistance RHP by dividing the voltage value of the third detection voltage Vd3 by the known current value of the detection current Itb, calculates the resistance value VRLC of the contact resistance RLC by dividing the voltage value of the fourth detection voltage Vd4 by the known current value of the detection current Ita, and calculates the resistance value VRLP of the contact resistance RLP by dividing the voltage value of the fifth detection voltage Vd5 by the known current value of the detection current Itb. In this manner, the internal resistance Rx of the measurement target DUT and the resistance values VRx, VRHC, VRHP, VRLC and VRLP of the contact resistances RHC, RHP, RLC and RLP are directly calculated through a single arithmetic processing without performing subtraction processing.

Subsequently, the processor 14 stores the calculated resistance values VRx, VRHC, VRHP, VRLC and VRLP in the internal memory. Next, the processor 14 executes output processing to output the data Dd to the outputter 15, and displays the calculated resistance value VRx of the internal resistance Rx and the resistance values VRHC, VRHP, VRLC and VRLP of the contact resistances RHC, RHP, RLC and RLP on the outputter 15. In this manner, the calculation (measurement) of the resistance value VRx of the internal resistance Rx of the measurement target DUT, and the calculation (measurement) of the resistance values VRHC, VRHP, VRLC and VRLP of the contact resistances RHC, RHP, RLC and RLP of the impedance measuring device 1A are completed. Note that when the calculated resistance values VRHC, VRHP, VRLC and VRLP are greater than a predetermined resistance value, the processor 14 causes the outputter 15 to display a prompt for re-measurement, since the presence of a contact failure or a defective measurement cable is assumed in one of the paths.

In this manner, according to the impedance measuring device 1A and the impedance measuring method, the detection current Ita is supplied to the first current path IR1 that includes the Hi-side source terminal Hc, the measurement target DUT, and one of the Lo-side source terminal Lc and the Lo-side sense terminal Lp (in this example, the Lo-side source terminal Lc), the detection current Itb is supplied to the second current path IR2 that includes the Hi-side sense terminal Hp, the measurement target DUT, and the other of the Lo-side source terminal Lc and the Lo-side sense terminal Lp (in this example, the Lo-side sense terminal Lp), the voltage generated between the Hi-side source terminal Hc and the Hi-side sense terminal Hp and the voltage generated between the Lo-side source terminal Lc and the Lo-side sense terminal Lp during supply of the detection current Ita and the detection current Itb are detected as detection voltages (in this example, the detection voltages Vd2 to Vd5), and the impedance of each path is measured based on the detected detection voltages, whereby the resistance values VRHC, VRHP, VRLC and VRLP of the contact resistances RHC, RHP, RLC and RLP can be directly calculated without performing subtraction processing. Accordingly, according to the impedance measuring device 1A and the impedance measuring method, the resistance values VRHC, VRHP, VRLC and VRLP of the contact resistances RHC, RHP, RLC and RLP, which represent the connection states of the Hi-side source terminal Hc, the Hi-side sense terminal Hp, the Lo-side source terminal Lc and the Lo-side sense terminal Lp with respect to the measurement target DUT during four-terminal measurement, can be individually and correctly measured (calculated).

In addition, according to the impedance measuring device 1A, the detection signal source 12 supplies the detection current Ita and the detection current Itb of AC current, the synchronous detection circuits 22b to 22e of detector 13A synchronously detect voltages generated between the terminals Hc, Hp, Lc and Lp with the synchronization signals Sf2 and Sf3 with the same frequencies as the frequencies (f1 and f2) of the detection currents Ita and Itb to detect them as the detection voltages Vd2 to Vd5, and the processor 14 calculates each path impedance (in this example, the resistance values VRHC, VRHP, VRLC and VRLP of the contact resistances RHC, RHP, RLC and RLP) based on the detection voltages Vd2 to Vd5 detected by the synchronous detection circuits 22b to 22e and the low-pass filters 23b to 23e, whereby each path impedance can be reliably and correctly calculated with a simple configuration.

In addition, according to the impedance measuring device 1A, the detector 13A is configured with the synchronous detection circuits 22a to 22e, and the processor 14 uses the voltage value of the first detection voltage Vd1 as the voltage value of the AC voltage generated between the positive electrode and negative electrode of the measurement target DUT when the AC measurement current Im is supplied to the measurement target DUT so as to calculate the resistance value VRx of the internal resistance Rx of the measurement target DUT based on that voltage value of the AC voltage and the current value of the AC measurement current Im, and calculates each path impedance (in this example, the resistance values VRHC, VRHP, VRLC and VRLP of the contact resistance RHC, the contact resistance RHP, the contact resistance RLC and the contact resistance RLP) based on the second detection voltage Vd2, the third detection voltage Vd3, the fourth detection voltage Vd4 and the fifth detection voltage Vd5, whereby each impedance can be simultaneously calculated in parallel, and the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in a short time.

In addition, according to the impedance measuring device 1A, the frequency f2 of the detection current Ita and the frequency f3 of the detection current Itb are defined as values different from each other, and thus each path impedance between the source terminals Hc and Lc and the sense terminals Hp and Lp, and the measurement target DUT (in this example, the resistance values VRHC, VRHP, VRLC and VRLP of the contact resistance RHC, the contact resistance RHP, the contact resistance RLC and the contact resistance RLP) can be simultaneously calculated in parallel.

In addition, according to the impedance measuring device 1A, the frequency f1 of the AC measurement current Im, the frequency f2 of the detection current Ita and the frequency f3 of the detection current Itb are defined as values different from each other, and thus the impedance of the measurement target DUT (in this example, the resistance value VRx of the internal resistance Rx), and each path impedance between the source terminals Hc and Lc and the sense terminals Hp and Lp, and the measurement target DUT (in this example, the resistance values VRHC, VRHP, VRLC and VRLP of the contact resistance RHC, the contact resistance RHP, the contact resistance RLC and the contact resistance RLP) can be simultaneously calculated in parallel. Accordingly, according to the impedance measuring device 1A, the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in the shortest time.

### Modifications of First Example

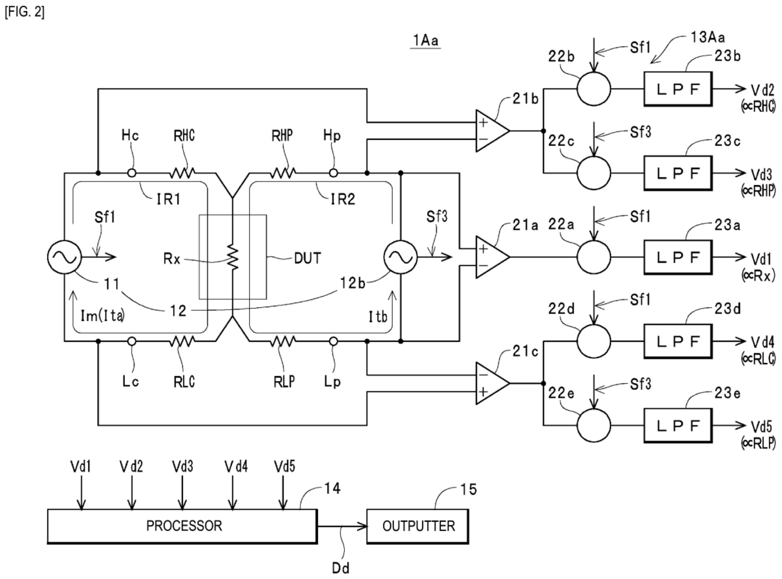

The above-described impedance measuring device 1A may also be simply configured. With reference to FIG. 2, an impedance measuring device 1Aa obtained by simplifying the configuration of the impedance measuring device 1A is described below. Note that in the following descriptions of various impedance measuring devices, components that functionally operate in the same manner as those of the impedance measuring device 1A are designated with the same reference numerals, and redundant descriptions are omitted, with explanations provided only for the differing configurations and operations.

As illustrated in FIG. 2, the impedance measuring device 1Aa includes the terminals Hc, Lc, Hp and Lp, the measurement signal source 11, the second detection signal generation circuit 12b, a detector 13Aa, the processor 14 and the outputter 15. The impedance measuring device 1Aa is configured without the arrangement of the first detection signal generation circuit 12a. In this case, the measurement signal source 11 functions as a measurement signal source and also as the detection signal source 12 in conjunction with the second detection signal generation circuit 12b, and supplies the AC measurement current Im to the first current path IR1 as a first detection current (the detection current Ita). Note that in the case where the measurement signal source 11 is configured such that the frequency of the generated AC signal can be changed, the frequency of the signal output as the AC measurement current Im and the frequency of the signal output as the detection current Ita may be set to different frequencies.

In addition, in the detector 13Aa, by multiplying a signal output from the amplification circuit 21b with the synchronization signal Sf1 output from the measurement signal source 11 (in other words, by synchronously detecting a signal output from the amplification circuit 21b with this synchronization signal Sf1), the synchronous detection circuit 22b outputs a DC signal whose voltage value varies in accordance with the voltage value (for example, amplitude) of the AC voltage generated across the contact resistance RHC when the AC measurement current Im flows through the contact resistance RHC. In addition, the low-pass filter 23b receives a DC signal with a superimposed AC component output from the synchronous detection circuit 22b, and performs smoothing by removing the AC component, thereby outputting the second detection voltage Vd2.

In this case, the second detection voltage Vd2 is a voltage that is obtained based on the voltage generated between the sense terminal Hp and the source terminal Hc due to the AC measurement current Im flowing through the contact resistance RHC, and therefore its voltage value is a value (∝VRHC) proportional to the resistance value VRHC of the contact resistance RHC. In this manner, by dividing the voltage value of the second detection voltage Vd2 by the known current value of the AC measurement current Im, the resistance value VRHC of the contact resistance RHC is directly calculated.

In addition, by multiplying a signal output from the amplification circuit 21c with the synchronization signal Sf1 output from the measurement signal source 11 (in other words, by synchronously detecting a signal output from the amplification circuit 21c with this synchronization signal Sf1), the synchronous detection circuit 22d outputs a DC signal whose voltage value varies in accordance with the voltage value (for example, amplitude) of the AC voltage generated across the contact resistance RLC when the AC measurement current Im flows through the contact resistance RLC. In addition, the low-pass filter 23d receives a DC signal with a superimposed AC component output from the synchronous detection circuit 22d, and performs smoothing by removing the AC component, thereby outputting the fourth detection voltage Vd4.

In this case, the fourth detection voltage Vd4 is a voltage that is obtained based on the voltage generated between the sense terminal Lp and the source terminal Lc due to the AC measurement current Im flowing through the contact resistance RLC, and therefore its voltage value is a value (∝VRLC) proportional to the resistance value VRLC of the contact resistance RLC. In this manner, by dividing the voltage value of the fourth detection voltage Vd4 by the known current value of the AC measurement current Im, the resistance value VRLC of the contact resistance RLC is directly calculated.

In the impedance measuring device 1Aa as well, the processor 14, as with the processor 14 in the impedance measuring device 1A, directly calculates the internal resistance Rx of the measurement target DUT and the resistance values VRx, VRHC, VRHP, VRLC and VRLP of the contact resistances RHC, RHP, RLC and RLP based on the first detection voltage Vd1 to the fifth detection voltage Vd5 without performing subtraction processing.

In this manner, according to the impedance measuring device 1Aa and the impedance measuring method, the measurement signal source 11 supplies the AC measurement current Im as the first detection current (in this example, the detection current It1), and thus, with a simple configuration provided with no first detection signal generation circuit 12a, it is possible to directly calculate the resistance values VRHC, VRHP, VRLC and VRLP of the contact resistances RHC, RHP, RLC and RLP through a single arithmetic processing without performing subtraction processing as with the impedance measuring device 1A, while achieving the effects of the impedance measuring device 1A. Accordingly, according to the impedance measuring device 1Aa and the impedance measuring method, the resistance values VRHC, VRHP, VRLC and VRLP of the contact resistances RHC, RHP, RLC and RLP, which represent the connection states of the Hi-side source terminal Hc, the Hi-side sense terminal Hp, the Lo-side source terminal Lc and the Lo-side sense terminal Lp with respect to the measurement target DUT during four-terminal measurement, can be individually and correctly measured (calculated) with a simple configuration.

### Example 2

Next, an impedance measuring device 1B serving as another impedance measuring device is described.

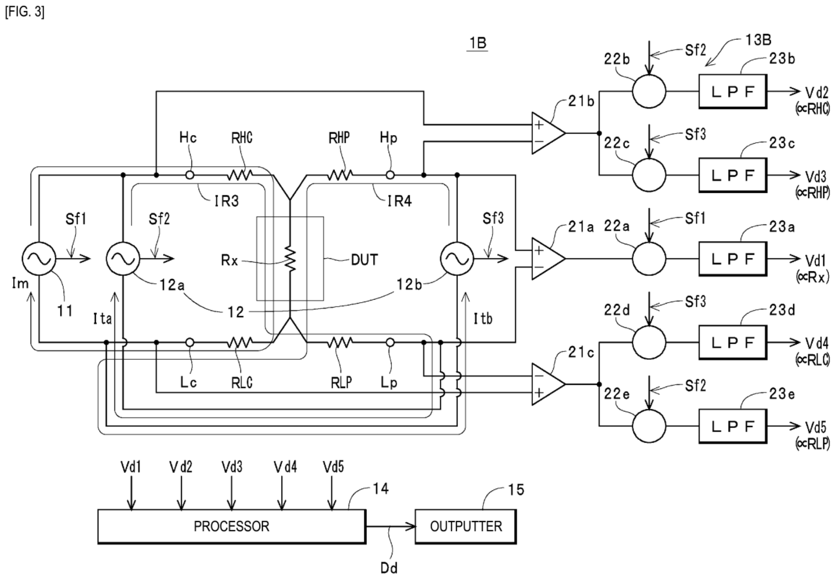

As illustrated in FIG. 3, the impedance measuring device 1B includes the terminals Hc, Lc, Hp and Lp, the measurement signal source 11, the detection signal source 12, a detector 13B, the processor 14 and the outputter 15.

The detection signal source 12 includes the first detection signal generation circuit 12a and the second detection signal generation circuit 12b, and supplies a detection current for detecting each path impedance of each path between the source terminals Hc and Lc and the sense terminals Hp and Lp and the positive electrode and negative electrode of the measurement target DUT. The first detection signal generation circuit 12a is connected between the Hi-side source terminal Hc and the Lo-side sense terminal Lp, generates the detection current Ita serving as the first detection current for detecting a path impedance composed of contact resistance and wiring resistance in a first current path IR3 that includes the Hi-side source terminal Hc, the measurement target DUT, and the Lo-side sense terminal Lp as one of the Lo-side source terminal Lc and the Lo-side sense terminal Lp (an impedance composed of contact resistance and wiring resistance in the path between the Hi-side source terminal Hc and the positive electrode of the measurement target DUT, and an impedance composed of contact resistance and wiring resistance in the path between the Lo-side sense terminal Lp and the negative electrode of the measurement target DUT), and supplies it to the first current path IR3. In this case, the first detection signal generation circuit 12a generates and outputs a sinusoidal AC current defined with a constant (known) amplitude and the constant frequency f2 as the detection current Ita. In addition, the first detection signal generation circuit 12a outputs the synchronization signal Sf2 having the same frequency f2 and synchronized with the detection current Ita.

The second detection signal generation circuit 12b is connected between the Hi-side sense terminal Hp and the Lo-side source terminal Lc, generates the detection current Itb serving as the second detection current for detecting a path impedance composed of contact resistance and wiring resistance in a second current path IR4 that includes the Hi-side sense terminal Hp, the measurement target DUT, and the Lo-side source terminal Lc as the other of the Lo-side source terminal Lc and the Lo-side sense terminal Lp (an impedance composed of contact resistance and wiring resistance in the path between the Hi-side sense terminal Hp and the positive electrode of the measurement target DUT, and an impedance composed of contact resistance and wiring resistance in the path between the Lo-side source terminal Lc and the negative electrode of the measurement target DUT), and supplies it to the second current path IR4. In this case, the second detection signal generation circuit 12b generates and outputs a sinusoidal AC current defined with a constant (known) amplitude and constant frequency f3 as the detection current Itb. In addition, the second detection signal generation circuit 12b outputs the synchronization signal Sf3 having the same the frequency f3 and synchronized with the detection current Itb.

In addition, in the detector 13B, by multiplying a signal output from the amplification circuit 21c with the synchronization signal Sf3 output from the second detection signal generation circuit 12b (in other words, by synchronously detecting a signal output from the amplification circuit 21c with this synchronization signal Sf3), the synchronous detection circuit 22d outputs a DC signal whose voltage value varies in accordance with the voltage value (for example, amplitude) of the AC voltage generated across the contact resistance RLC when the detection current Itb flows through the contact resistance RLC. In addition, the low-pass filter 23d receives a DC signal with a superimposed AC component output from the synchronous detection circuit 22d, and performs smoothing by removing the AC component, thereby outputting the fourth detection voltage Vd4.

In this case, the fourth detection voltage Vd4 is a voltage that is obtained based on the voltage generated between the sense terminal Lp and the source terminal Lc due to the detection current Itb flowing through the contact resistance RLC, and therefore its voltage value is a value (∝VRLC) proportional to the resistance value VRLC of the contact resistance RLC. In this manner, by dividing the voltage value of the fourth detection voltage Vd4 by the known current value of the detection current Itb, the resistance value VRLC of the contact resistance RLC is directly calculated.

In addition, by multiplying a signal output from the amplification circuit 21c with the synchronization signal Sf2 output from the first detection signal generation circuit 12a (in other words, by synchronously detecting a signal output from the amplification circuit 21c with this synchronization signal Sf2), the synchronous detection circuit 22e outputs a DC signal whose voltage value varies in accordance with the voltage value (for example, amplitude) of the AC voltage generated across the contact resistance RLP when the detection current Itb flows through the contact resistance RLP. In addition, the low-pass filter 23e receives a DC signal with a superimposed AC component output from the synchronous detection circuit 22e, and performs smoothing by removing the AC component, thereby outputting the fifth detection voltage Vd5.

In this case, the fifth detection voltage Vd5 is a voltage that is obtained based on the voltage generated between the sense terminal Lp and the source terminal Lc due to the detection current Ita flowing through the contact resistance RLP, and therefore its voltage value is a value (∝VRLP) proportional to the resistance value VRLP of the contact resistance RLP. In this manner, by dividing the voltage value of the fifth detection voltage Vd5 by the known current value of the detection current Ita, the resistance value VRLP of the contact resistance RLP is directly calculated.

In the impedance measuring device 1B as well, the processor 14, as with the processor 14 in the impedance measuring device 1A, directly calculates the internal resistance Rx of the measurement target DUT and the resistance values VRx, VRHC, VRHP, VRLC and VRLP of the contact resistances RHC, RHP, RLC and RLP through a single arithmetic processing without performing subtraction processing based on the first detection voltage Vd1 to the fifth detection voltage Vd5.

In this manner, according to the impedance measuring device 1B and the impedance measuring method, the detection current Ita is supplied to the first current path IR3 that includes the Hi-side source terminal Hc, the measurement target DUT, and one of the Lo-side source terminal Lc and the Lo-side sense terminal Lp (in this example, the Lo-side sense terminal Lp), the detection current Itb is supplied to the second current path IR4 that includes the Hi-side sense terminal Hp, the measurement target DUT, and the other of the Lo-side source terminal Lc and the Lo-side sense terminal Lp (in this example, the Lo-side source terminal Lc), the voltage generated between the Hi-side source terminal Hc and the Hi-side sense terminal Hp and the voltage generated between the Lo-side source terminal Lc and the Lo-side sense terminal Lp during supply of the detection current Ita and the detection current Itb are detected as detection voltages (in this example, the detection voltages Vd2 to Vd5), and the impedance of each path is measured based on the detected detection voltages, whereby the resistance values VRHC, VRHP, VRLC and VRLP of the contact resistances RHC, RHP, RLC and RLP can be directly calculated without performing subtraction processing. Accordingly, according to the impedance measuring device 1B and the impedance measuring method, the resistance values VRHC, VRHP, VRLC and VRLP of the contact resistances RHC, RHP, RLC and RLP, which represent the connection states of the Hi-side source terminal Hc, the Hi-side sense terminal Hp, the Lo-side source terminal Lc and the Lo-side sense terminal Lp with respect to the measurement target DUT during four-terminal measurement, can be individually and correctly measured (calculated).

In addition, according to the impedance measuring device 1B, the detection signal source 12 supplies the detection current Ita and the detection current Itb of AC current, the synchronous detection circuits 22b to 22e of the detector 13B synchronously detect voltages generated between the terminals Hc, Hp, Lc and Lp with the synchronization signals Sf2 and Sf3 with the same frequencies as the frequencies (f1 and f2) of the detection currents Ita and Itb to detect them as the detection voltages Vd2 to Vd5, and the processor 14 calculates each path impedance (in this example, the resistance values VRHC, VRHP, VRLC and VRLP of the contact resistances RHC, RHP, RLC and RLP) based on the detection voltages Vd2 to Vd5 detected by the synchronous detection circuits 22b to 22e and the low-pass filters 23b to 23e, whereby each path impedance can be reliably and correctly calculated with a simple configuration.

In addition, according to the impedance measuring device 1B, the detector 13B is configured with the synchronous detection circuits 22a to 22e, the processor 14 uses the voltage value of the first detection voltage Vd1 as the voltage value of the AC voltage generated between the positive electrode and negative electrode of the measurement target DUT when the AC measurement current Im is supplied to the measurement target DUT so as to calculate the resistance value VRx of the internal resistance Rx of the measurement target DUT based on that voltage value of the AC voltage and the current value of the AC measurement current Im, and calculates each path impedance (in this example, the resistance values VRHC, VRHP, VRLC and VRLP of the contact resistance RHC, the contact resistance RHP, the contact resistance RLC and the contact resistance RLP) based on the second detection voltage Vd2, the third detection voltage Vd3, the fourth detection voltage Vd4 and the fifth detection voltage Vd5, whereby each impedance can be simultaneously calculated in parallel, and the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in a short time.

In addition, according to the impedance measuring device 1B, the frequency f2 of the detection current Ita and the frequency f3 of the detection current Itb are defined as values different from each other, and thus each path impedance between the source terminals Hc and Lc and the sense terminals Hp and Lp, and the measurement target DUT (in this example, the resistance values VRHC, VRHP, VRLC and VRLP of the contact resistance RHC, the contact resistance RHP, the contact resistance RLC and the contact resistance RLP) can be simultaneously calculated in parallel.

In addition, according to the impedance measuring device 1B, the frequency f1 of the AC measurement current Im, the frequency f2 of the detection current Ita and the frequency f3 of the detection current Itb are defined as values different from each other, and thus the impedance of the measurement target DUT (in this example, the resistance value VRx of the internal resistance Rx), and each path impedance between the source terminals Hc and Lc and the sense terminals Hp and Lp, and the measurement target OUT (in this example, the resistance values VRHC, VRHP, VRLC and VRLP of the contact resistance RHC, the contact resistance RHP, the contact resistance RLC and the contact resistance RLP) can be simultaneously calculated in parallel. Accordingly, according to the impedance measuring device 1B, the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in the shortest time.

### Example 3

Next, an impedance measuring device 1C serving as another impedance measuring device is described.

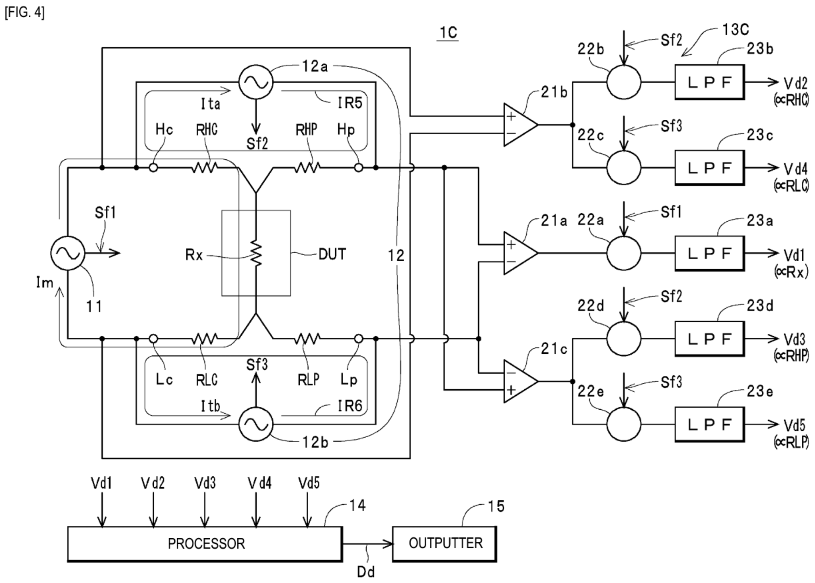

As illustrated in FIG. 4, the impedance measuring device 1C includes the terminals Hc, Lc, Hp and Lp, the measurement signal source 11, the detection signal source 12, a detector 13C, the processor 14 and the outputter 15.

The detection signal source 12 includes the first detection signal generation circuit 12a and the second detection signal generation circuit 12b, and supplies a detection current for detecting each path impedance of each path between the source terminals Hc and Lc and the sense terminals Hp and Lp and the positive electrode and negative electrode of the measurement target DUT. The first detection signal generation circuit 12a is connected between the Hi-side source terminal Hc and the Hi-side sense terminal Hp, generates the detection current Ita serving as the first detection current for detecting a path impedance composed of contact resistance and wiring resistance in a first current path IR5 that includes the Hi-side source terminal Hc and the Hi-side sense terminal Hp but does not include the measurement target DUT (an impedance composed of contact resistance and wiring resistance in the path between the Hi-side source terminal Hc and the positive electrode of the measurement target DUT, and an impedance composed of contact resistance and wiring resistance in the path between the Hi-side sense terminal Hp and the positive electrode of the measurement target DUT), and supplies it to the first current path IR5. In this case, the first detection signal generation circuit 12a generates and outputs a sinusoidal AC current defined with a constant (known) amplitude and the constant frequency f2 as the detection current Ita. In addition, the first detection signal generation circuit 12a outputs the synchronization signal Sf2 having the same frequency f2 and synchronized with the detection current Ita.

The second detection signal generation circuit 12b is connected between the Lo-side source terminal Lc and the Lo-side sense terminal Lp, generates the detection current Itb serving as the second detection current for detecting a path impedance composed of contact resistance and wiring resistance in a second current path IR6 that includes the Lo-side source terminal Lc and the Lo-side sense terminal Lp but does not include the measurement target OUT (an impedance composed of contact resistance and wiring resistance in the path between the Lo-side source terminal Lc and the negative electrode of the measurement target DUT, and an impedance composed of contact resistance and wiring resistance in the path between the Lo-side sense terminal Lp and the negative electrode of the measurement target DUT), and supplies it to second current path IR6. In this case, the second detection signal generation circuit 12b generates and outputs a sinusoidal AC current defined with a constant (known) amplitude and a constant frequency f3 having a frequency value different from the frequencies f1 and f2 as the detection current Itb. In addition, the second detection signal generation circuit 12b outputs the synchronization signal Sf3 having the same the frequency f3 and synchronized with the detection current Itb.

The detector 13C includes the amplification circuits 21a to 21c, the synchronous detection circuits 22a to 22e, and the low-pass filters 23a to 23e, detects, through the Hi-side sense terminal Hp and the Lo-side sense terminal Lp, an AC voltage generated between the positive electrode and negative electrode of the measurement target DUT due to the supply of the AC measurement current Im, and detects each voltage generated in each of the above-described paths due to the supply of the detection currents Ita and Itb as a detection voltage.

The amplification circuit 21b is provided with a non-inverting input terminal connected to the Hi-side source terminal Hc and an inverting input terminal connected to the Lo-side source terminal Lc, and outputs, with a defined gain, the voltage difference between the voltage of the source terminal Lc and the voltage of the source terminal Hc. Accordingly, the amplification circuit 21b outputs an AC signal whose voltage value varies in accordance with the voltage value (for example, amplitude) of a voltage that is the sum of the voltage generated across the contact resistance RHC when the detection current Ita flows through the contact resistance RHC and the voltage generated across the contact resistance RLC when the detection current Itb flows through the contact resistance RLC. The amplification circuit 21c is provided with a non-inverting input terminal connected to the Hi-side sense terminal Hp and an inverting input terminal connected to the Lo-side sense terminal Lp, and outputs, with a defined gain, the voltage difference between the voltage of the sense terminal Lp and the voltage of the sense terminal Hp. Accordingly, the amplification circuit 21c outputs an AC signal whose voltage value varies in accordance with the voltage value (for example, amplitude) of a voltage that is the sum of the voltage generated across the contact resistance RHP when the detection current Ita flows through the contact resistance RHP and the voltage generated across the contact resistance RLP when the detection current Itb flows through the contact resistance RLP. Note that in the voltage output apparatus 1C, both the amplification circuit 21a and the amplification circuit 21c are configured to output, with a defined gain, the voltage difference between the voltage of the sense terminal Hp and the voltage of the sense terminal Lp. As such, it is possible to employ a configuration in which the arrangement of the amplification circuit 21c is omitted, and the outputter of the amplification circuit 21a is connected to the inputters of the synchronous detection circuits 22d and 22e such that the amplification circuit 21a functions also as the amplification circuit 21c.

The synchronous detection circuit 22b functions as a second synchronous detection circuit together with the low-pass filter 23b, and by multiplying a signal output from the amplification circuit 21b with the synchronization signal Sf2 output from the first detection signal generation circuit 12a (in other words, by synchronously detecting a signal output from the amplification circuit 21b with this synchronization signal Sf2), outputs a DC signal whose voltage value varies in accordance with the voltage value (for example, amplitude) of the AC voltage generated across the contact resistance RHC when the detection current Ita flows through the contact resistance RHC. In addition, the low-pass filter 23b receives a DC signal with a superimposed AC component output from the synchronous detection circuit 22b, and performs smoothing by removing the AC component, thereby outputting the second detection voltage Vd2.

In this case, the second detection voltage Vd2 is a voltage that is obtained based on the voltage generated between the sense terminal Hp and the source terminal Hc due to the detection current Ita flowing through the contact resistance RHC, and therefore its voltage value is a value (∝VRHC) proportional to the resistance value VRHC of the contact resistance RHC. In this manner, by dividing the voltage value of the second detection voltage Vd2 by the known current value of the detection current Ita, the resistance value VRHC of the contact resistance RHC is directly calculated.

The synchronous detection circuit 22c functions as a fourth synchronous detection circuit together with the low-pass filter 23c, and by multiplying a signal output from the amplification circuit 21b with the synchronization signal Sf3 output from the second detection signal generation circuit 12b (in other words, by synchronously detecting a signal output from the amplification circuit 21b with this synchronization signal Sf3), outputs a DC signal whose voltage value varies in accordance with the voltage value (for example, amplitude) of the AC voltage generated across the contact resistance RLC when the detection current Itb flows through the contact resistance RLC. In addition, the low-pass filter 23c receives a DC signal with a superimposed AC component output from the synchronous detection circuit 22c, and performs smoothing by removing the AC component, thereby outputting the fourth detection voltage Vd4.

In this case, the fourth detection voltage Vd4 is a voltage that is obtained based on the voltage generated between the source terminal Lc and the source terminal Hc due to the detection current Itb flowing through the contact resistance RLC, and therefore its voltage value is a value (∝VRLC) proportional to the resistance value VRLC of the contact resistance RLC. In this manner, by dividing the voltage value of the fourth detection voltage Vd4 by the known current value of the detection current Itb, the resistance value VRLC of the contact resistance RLC is directly calculated.

The synchronous detection circuit 22d functions as a third synchronous detection circuit together with the low-pass filter 23d, and by multiplying a signal output from the amplification circuit 21c with the synchronization signal Sf2 output from the first detection signal generation circuit 12a (in other words, by synchronously detecting a signal output from the amplification circuit 21c with this synchronization signal Sf2), outputs a DC signal whose voltage value varies in accordance with the voltage value (for example, amplitude) of the AC voltage generated across the contact resistance RHP when the detection current Ita flows through the contact resistance RHP. In addition, the low-pass filter 23d receives a DC signal with a superimposed AC component output from the synchronous detection circuit 22d, and performs smoothing by removing the AC component, thereby outputting the third detection voltage Vd3.

In this case, the third detection voltage Vd3 is a voltage that is obtained based on the voltage generated between the sense terminal Lp and the sense terminal Lp due to the detection current Ita flowing through the contact resistance RHP, and therefore its voltage value is a value (∝VRHP) proportional to the resistance value VRHP of the contact resistance RHP. In this manner, by dividing the voltage value of the third detection voltage Vd3 by the known current value of the detection current Ita, the resistance value VRHP of the contact resistance RHP is directly calculated.

The synchronous detection circuit 22e functions as a fifth synchronous detection circuit together with the low-pass filter 23e, and by multiplying a signal output from the amplification circuit 21c with the synchronization signal Sf3 output from the second detection signal generation circuit 12b (in other words, by synchronously detecting a signal output from the amplification circuit 21c with this synchronization signal Sf3), outputs a DC signal whose voltage value varies in accordance with the voltage value (for example, amplitude) of the AC voltage generated across the contact resistance RLP when the detection current Itb flows through the contact resistance RLP. In addition, the low-pass filter 23e receives a DC signal with a superimposed AC component output from the synchronous detection circuit 22e, and performs smoothing by removing the AC component, thereby outputting the fifth detection voltage Vd5.

In this case, the fifth detection voltage Vd5 is a voltage that is obtained based on the voltage generated between the sense terminal Lp and the sense terminal Lp due to the detection current Itb flowing through the contact resistance RLP, and therefore its voltage value is a value (∝VRLP) proportional to the resistance value VRLP of the contact resistance RLP. In this manner, by dividing the voltage value of the fifth detection voltage Vd5 by the known current value of the detection current Itb, the resistance value VRLP of the contact resistance RLP is directly calculated.

In the impedance measuring device 1C as well, the processor 14, as with the processor 14 in the impedance measuring device 1A, directly calculates the resistance value VRx of the internal resistance Rx of the measurement target DUT and the resistance values VRx, VRHC, VRHP, VRLC and VRLP of the contact resistances RHC, RHP, RLC and RLP through a single arithmetic processing based on the first detection voltage Vd1 to the fifth detection voltage Vd5, without performing subtraction processing.

In this manner, according to the impedance measuring device 1C and the impedance measuring method, the detection current Ita is supplied to the first current path IR5 that includes the Hi-side source terminal Hc and the Hi-side sense terminal Hp but does not include the measurement target DUT, the detection current Itb is supplied to the second current path IR6 that includes the Lo-side source terminal Lc and the Lo-side sense terminal Lp but does not include the measurement target DUT, the voltage generated between the Hi-side source terminal Hc and one of the Lo-side source terminal Lc and the Lo-side sense terminal Lp (in this example, the Lo-side source terminal Lc) and the voltage generated between the Hi-side sense terminal Hp and the other of the Lo-side source terminal Lc and the Lo-side sense terminal Lp (in this example, the Lo-side sense terminal Lp) during supply of the detection current Ita and the detection current Itb are detected as detection voltages (in this example, the detection voltages Vd2 to Vd5), and the impedance of each path is measured based on the detected detection voltages, whereby the resistance values VRHC, VRHP, VRLC and VRLP of the contact resistances RHC, RHP, RLC and RLP can be directly calculated without performing subtraction processing. Accordingly, according to the impedance measuring device 1C and the impedance measuring method, the resistance values VRHC, VRHP, VRLC and VRLP of the contact resistances RHC, RHP, RLC and RLP, which represent the connection states of the Hi-side source terminal Hc, the Hi-side sense terminal Hp, the Lo-side source terminal Lc and the Lo-side sense terminal Lp with respect to the measurement target DUT during four-terminal measurement, can be individually and correctly measured (calculated).

In addition, according to the impedance measuring device 1C, the detection signal source 12 supplies the detection current Ita and the detection current Itb of AC current, the synchronous detection circuits 22b to 22e of the detector 13C synchronously detect voltages generated between the terminals Hc, Hp, Lc and Lp with the synchronization signals Sf2 and Sf3 with the same frequencies as the frequencies (f1 and f2) of the detection currents Ita and Itb to detect them as the detection voltages Vd2 to Vd5, and the processor 14 calculates each path impedance (in this example, the resistance values VRHC, VRHP, VRLC and VRLP of the contact resistances RHC, RHP, RLC and RLP) based on the detection voltages Vd2 to Vd5 detected by the synchronous detection circuits 22b to 22e and the low-pass filters 23b to 23e, whereby each path impedance can be reliably and correctly calculated with a simple configuration.

In addition, according to the impedance measuring device 1C, the detector 13C is configured with the synchronous detection circuits 22a to 22e, and the processor 14 uses the voltage value of the first detection voltage Vd1 as the voltage value of the AC voltage generated between the positive electrode and negative electrode of the measurement target DUT when the AC measurement current Im is supplied to the measurement target DUT so as to calculate the resistance value VRx of the internal resistance Rx of the measurement target DUT based on that voltage value of the AC voltage and the current value of the AC measurement current Im, and calculates each path impedance (in this example, the resistance values VRHC, VRHP, VRLC and VRLP of the contact resistance RHC, the contact resistance RHP, the contact resistance RLC and the contact resistance RLP) based on the second detection voltage Vd2, the third detection voltage Vd3, the fourth detection voltage Vd4 and the fifth detection voltage Vd5, whereby each impedance can be simultaneously calculated in parallel, and the impedance of the measurement target DUT (in this example, the resistance value VRx of the internal resistance Rx) and each path impedance (in this example, the resistance values VRx, VRHC, VRHP, VRLC and VRLP of the contact resistances RHC, RHP, RLC and RLP) can be calculated in a short time.

In addition, according to the impedance measuring device 1C, the frequency f2 of the detection current Ita and the frequency f3 of the detection current Itb are defined as values different from each other, and thus each path impedance between the source terminals Hc and Lc and the sense terminals Hp and Lp, and the measurement target DUT (in this example, the resistance values VRx, VRHC, VRHP, VRLC and VRLP of the contact resistance RHC, the contact resistance RHP, the contact resistance RLC and the contact resistance RLP) can be simultaneously calculated in parallel.

In addition, according to the impedance measuring device 1C, the frequency f1 of the AC measurement current Im, the frequency f2 of the detection current Ita and the frequency f3 of the detection current Itb are defined as values different from each other, and thus the impedance of the measurement target DUT (in this example, the resistance value VRx of the internal resistance Rx), and each path impedance between the source terminals Hc and Lc and the sense terminals Hp and Lp, and the measurement target DUT (in this example, the resistance values VRx, VRHC, VRHP, VRLC and VRLP of the contact resistance RHC, the contact resistance RHP, the contact resistance RLC and the contact resistance RLP) can be simultaneously calculated in parallel. Accordingly, according to the impedance measuring device 1C, the impedance of the measurement target DUT (in this example, the resistance value VRx of the internal resistance Rx) and each path impedance (in this example, the resistance values VRx, VRHC, VRHP, VRLC and VRLP of the contact resistances RHC, RHP, RLC and RLP) can be calculated in the shortest time.

### Example 4

Next, an impedance measuring device 1D serving as another impedance measuring device is described. Note that the following mainly describes configurations that differ from the components of the impedance measuring device 1C.

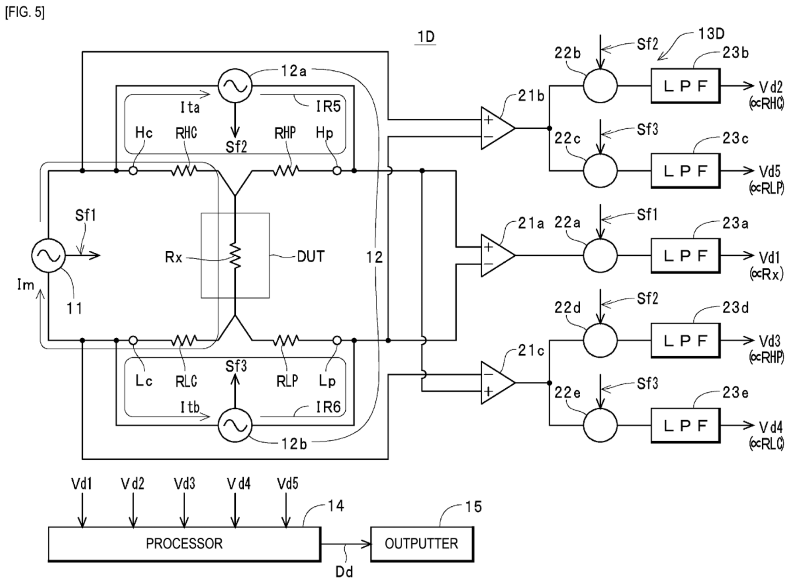

As illustrated in FIG. 5, the impedance measuring device 1D includes the terminals Hc, Lc, Hp and Lp, the measurement signal source 11, the detection signal source 12, a detector 13D, the processor 14 and the outputter 15.

The detector 13D includes the amplification circuits 21a to 21c, the synchronous detection circuits 22a to 22e, and the low-pass filters 23a to 23e, detects, through the Hi-side sense terminal Hp and the Lo-side sense terminal Lp, an AC voltage generated between the positive electrode and negative electrode of the measurement target DUT due to the supply of the AC measurement current Im, and detects each voltage generated in each of the above-described paths due to the supply of the detection currents Ita and Itb as a detection voltage.

The amplification circuit 21b is provided with a non-inverting input terminal connected to the Hi-side source terminal Hc and an inverting input terminal connected to the Lo-side sense terminal Lp, and outputs, with a defined gain, the voltage difference between the voltage of the sense terminal Lp and the voltage of the source terminal Hc. Accordingly, the amplification circuit 21b outputs an AC signal whose voltage value varies in accordance with the voltage value (for example, amplitude) of a voltage that is the sum of the voltage generated across the contact resistance RHC when the detection current Ita flows through the contact resistance RHC and the voltage generated across the contact resistance RLP when the detection current Itb flows through the contact resistance RLP. The amplification circuit 21c is provided with a non-inverting input terminal connected to the Hi-side sense terminal Hp and an inverting input terminal connected to the Lo-side source terminal Lc, and outputs, with a defined gain, the voltage difference between the voltage of the source terminal Lc and the voltage of the sense terminal Hp. Accordingly, the amplification circuit 21c outputs an AC signal whose voltage value varies in accordance with the voltage value (for example, amplitude) of a voltage that is the sum of the voltage generated across the contact resistance RHP when the detection current Ita flows through the contact resistance RHP and the voltage generated across the contact resistance RLC when the detection current Itb flows through the contact resistance RLC.

The synchronous detection circuit 22c functions as a fifth synchronous detection circuit together with the low-pass filter 23c, and by multiplying a signal output from the amplification circuit 21b with the synchronization signal Sf3 output from the second detection signal generation circuit 12b (in other words, by synchronously detecting a signal output from the amplification circuit 21b with this synchronization signal Sf3), outputs a DC signal whose voltage value varies in accordance with the voltage value (for example, amplitude) of the AC voltage generated across the contact resistance RLP when the detection current Itb flows through the contact resistance RLP. In addition, the low-pass filter 23c receives a DC signal with a superimposed AC component output from the synchronous detection circuit 22c, and performs smoothing by removing the AC component, thereby outputting the fifth detection voltage Vd5.

In this case, the fifth detection voltage Vd5 is a voltage that is obtained based on the voltage generated between the sense terminal Lp and the source terminal Hc due to the detection current Itb flowing through the contact resistance RLP, and therefore its voltage value is a value (∝VRLP) proportional to the resistance value VRLP of the contact resistance RLP. In this manner, by dividing the voltage value of the fifth detection voltage Vd5 by the known current value of the detection current Itb, the resistance value VRLP of the contact resistance RLP is directly calculated.

The synchronous detection circuit 22e functions as a fourth synchronous detection circuit together with the low-pass filter 23e, and by multiplying a signal output from the amplification circuit 21c with the synchronization signal Sf3 output from the second detection signal generation circuit 12b (in other words, by synchronously detecting a signal output from the amplification circuit 21c with this synchronization signal Sf3), outputs a DC signal whose voltage value varies in accordance with the voltage value (for example, amplitude) of the AC voltage generated across the contact resistance RLC when the detection current Itb flows through the contact resistance RLC. In addition, the low-pass filter 23e receives a DC signal with a superimposed AC component output from the synchronous detection circuit 22e, and performs smoothing by removing the AC component, thereby outputting the fourth detection voltage Vd4.

In this case, the fourth detection voltage Vd4 is a voltage that is obtained based on the voltage generated between the source terminal Lc and the sense terminal Hp due to the detection current Itb flowing through the contact resistance RLC, and therefore its voltage value is a value (∝VRLC) proportional to the resistance value VRLC of the contact resistance RLC. In this manner, by dividing the voltage value of the fourth detection voltage Vd4 by the known current value of the detection current Itb, the resistance value VRLC of the contact resistance RLC is directly calculated.

In the impedance measuring device 1D as well, the processor 14, as with the processor 14 in the impedance measuring device 1A, directly calculates the internal resistance Rx of the measurement target DUT and the resistance values VRx, VRHC, VRHP, VRLC and VRLP of the contact resistances RHC, RHP, RLC and RLP through a single arithmetic processing without performing subtraction processing based on the first detection voltage Vd1 to the fifth detection voltage Vd5.

In this manner, according to the impedance measuring device 1D and the impedance measuring method, the detection current Ita is supplied to the first current path IR5 that includes the Hi-side source terminal Hc and the Hi-side sense terminal Hp but does not include the measurement target DUT, the detection current Itb is supplied to the second current path IR6 that includes the Lo-side source terminal Lc and the Lo-side sense terminal Lp but does not include the measurement target DUT, the voltage generated between the Hi-side source terminal Hc and one of the Lo-side source terminal Lc and the Lo-side sense terminal Lp (in this example, the Lo-side sense terminal Lp), and the voltage generated between the Hi-side sense terminal Hp and the other of the Lo-side source terminal Lc and the Lo-side sense terminal Lp (in this example, the Lo-side source terminal Lc) during supply of the detection current Ita and the detection current Itb are detected as detection voltages (in this example, the detection voltages Vd2 to Vd5), and the impedance of each path is measured based on the detected detection voltages, whereby the resistance values VRHC, VRHP, VRLC and VRLP of the contact resistances RHC, RHP, RLC and RLP can be directly calculated without performing subtraction processing. Accordingly, according to the impedance measuring device 1D and the impedance measuring method, the resistance values VRHC, VRHP, VRLC and VRLP of the contact resistances RHC, RHP, RLC and RLP, which represent the connection states of the Hi-side source terminal Hc, the Hi-side sense terminal Hp, the Lo-side source terminal Lc and the Lo-side sense terminal Lp with respect to the measurement target DUT during four-terminal measurement, can be individually and correctly measured (calculated).

In addition, according to the impedance measuring device 1D, the detection signal source 12 supplies the detection current Ita and the detection current Itb of AC current, the synchronous detection circuits 22b to 22e of the detector 13D synchronously detect voltages generated between the terminals Hc, Hp, Lc and Lp with the synchronization signals Sf2 and Sf3 with the same frequencies as the frequencies (f1 and f2) of the detection currents Ita and Itb to detect them as the detection voltages Vd2 to Vd5, and the processor 14 calculates each path impedance (in this example, the resistance values VRHC, VRHP, VRLC and VRLP of the contact resistances RHC, RHP, RLC and RLP) based on the detection voltages Vd2 to Vd5 detected by the synchronous detection circuits 22b to 22e and the low-pass filters 23b to 23e, whereby each path impedance can be reliably and correctly calculated with a simple configuration.

In addition, according to the impedance measuring device 1D, the detector 13D is configured with the synchronous detection circuits 22a to 22e, and the processor 14 uses the voltage value of the first detection voltage Vd1 as the voltage value of the AC voltage generated between the positive electrode and negative electrode of the measurement target DUT when the AC measurement current Im is supplied to the measurement target DUT so as to calculate the resistance value VRx of the internal resistance Rx of the measurement target DUT based on that voltage value of the AC voltage and the current value of the AC measurement current Im, and calculates each path impedance (in this example, the resistance values VRHC, VRHP, VRLC and VRLP of the contact resistance RHC, the contact resistance RHP, the contact resistance RLC and the contact resistance RLP) based on the second detection voltage Vd2, the third detection voltage Vd3, the fourth detection voltage Vd4 and the fifth detection voltage Vd5, whereby each impedance can be simultaneously calculated in parallel, and the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in a short time.

In addition, according to the impedance measuring device 1D, the frequency f2 of the detection current Ita and the frequency f3 of the detection current Itb are defined as values different from each other, and thus each path impedance between the source terminals Hc and Lc and the sense terminals Hp and Lp, and the measurement target DUT (in this example, the resistance values VRHC, VRHP, VRLC and VRLP of the contact resistance RHC, the contact resistance RHP, the contact resistance RLC and the contact resistance RLP) can be simultaneously calculated in parallel.

In addition, according to the impedance measuring device 1D, the frequency f1 of the AC measurement current Im, the frequency f2 of the detection current Ita and the frequency f3 of the detection current Itb are defined as values different from each other, and thus the impedance of the measurement target DUT (in this example, the resistance value VRx of the internal resistance Rx), and each path impedance between the source terminals Hc and Lc and the sense terminals Hp and Lp, and the measurement target DUT (in this example, the resistance values VRHC, VRHP, VRLC and VRLP of the contact resistance RHC, the contact resistance RHP, the contact resistance RLC and the contact resistance RLP) can be simultaneously calculated in parallel. Accordingly, according to the impedance measuring device 1D, the impedance of the measurement target DUT (in this example, the resistance value VRx of the internal resistance Rx) and each path impedance (in this example, the resistance values VRHC, VRHP, VRLC and VRLP of the contact resistances RHC, RHP, RLC and RLP) can be calculated in the shortest time.

Note that the present invention is not limited to the configurations and operations of the above-described examples. For example, in the above-described impedance measuring devices 1A, 1Aa, 1B, 1C and 1D, the frequency of the AC measurement current Im, the frequency of the detection current Ita and the frequency of the detection current Itb are defined as frequencies different from each other such that the supply of the detection currents Ita and Itb and the supply of the AC measurement current Im from the measurement signal source 11 to the measurement target DUT are simultaneously executed to simultaneously detect the first detection voltage Vd1 to the fifth detection voltage Vd5 in order to shorten the measurement time, but this is not limitative. More specifically, by setting the calculation timings for the resistance value VRx of the internal resistance Rx and the resistance values VRH, VRHP, VRLC and VRLP of the contact resistances RH, RHP, RLC and RLP to different timings, and supplying the required current among the AC measurement current Im, the detection current Ita and the detection current Itb in accordance with the timings, the frequencies can be defined as the same frequency, or any two of the frequencies among the frequency of the AC measurement current Im, the frequency of the detection current Ita and the frequency of the detection current Itb can be defined as the same frequency.

Note that in the configuration in which the supply timings of the AC measurement current Im, the detection current Ita and the detection current Itb are different from each other, the function of supplying the AC measurement current Im, the detection current Ita and the detection current Itb may be configured using one or two signal sources. This can be easily implemented by employing a configuration in which the one or two signal sources and a switch circuit that switchably connects the one or two signal sources to the respective current supply points are provided, and the switch circuit is controlled in accordance with the supply timings of the AC measurement current Im, the detection current Ita and the detection current Itb.

In addition, in the above-described impedance measuring devices 1A, 1Aa, 1B, 1C and 1D, since the amplification circuits 21a to 21c are composed of differential amplifier circuits, either a configuration in which the ground of the measurement signal source 11 side is common with the ground of each component of the impedance measuring devices 1A, 1Aa, 1B, 1C and 1D excluding the measurement signal source 11, or a configuration in which they are different can be employed. On the other hand, it is also possible to employ a configuration in which any one or two of the amplification circuits 21a to 21c are single-ended amplification circuits.

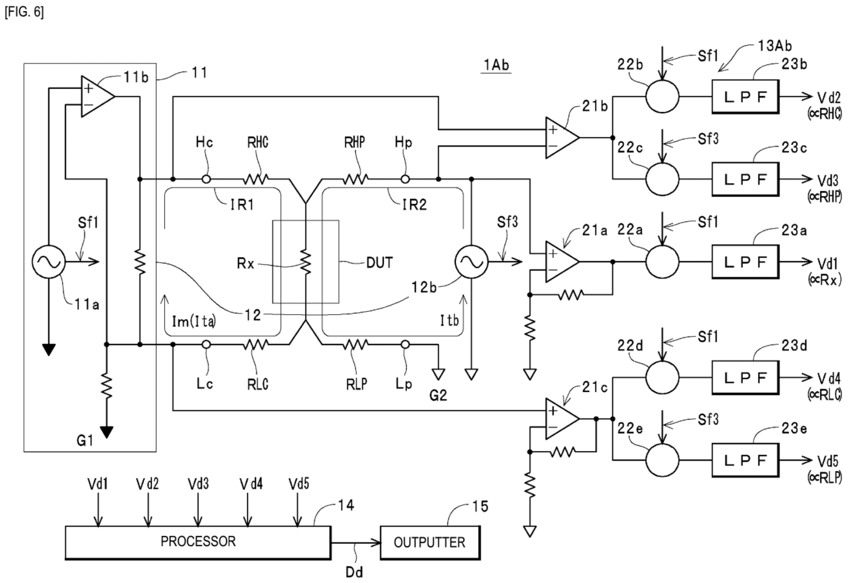

With reference to FIG. 6, for example, the following describes an impedance measuring device 1Ab in which a ground G1 of the measurement signal source 11 side in the impedance measuring device 1Aa and a ground G2 of each component of the impedance measuring device 1Aa excluding the measurement signal source 11 are different from each other. In the impedance measuring device 1Ab, an AC signal generation circuit 11a making up a part of the measurement signal source 11 operates with the ground G1 as a reference potential, and generates an AC signal serving as the basis of the AC measurement current Im. In addition, an amplification circuit 11b making up a part of the measurement signal source 11 operates with the ground G1 as a reference potential, amplifies the AC signal output from the AC signal generation circuit 11a, and outputs it as the AC measurement current Im.

In addition, in the impedance measuring device 1Ab excluding the measurement signal source 11, each component operates with the ground G2 as a reference potential. In this case, for example, in the case where a configuration is employed in which the Lo-side sense terminal Lp is set to the common potential with the ground G2, the detector 13Ab can be configured with the amplification circuits 21a and 21c as single-ended amplification circuits. The amplification circuit 21a is provided with a non-inverting input terminal connected to the Hi-side sense terminal Hp and an inverting input terminal connected to the Lo-side sense terminal Lp through the ground G2, and outputs, with a defined gain, the voltage difference between the voltage of the sense terminal Lp and the voltage of the sense terminal Hp. Accordingly, the amplification circuit 21a executes an operation similar to that of the amplification circuit 21a in the impedance measuring device 1Aa. In addition, the amplification circuit 21c is provided with a non-inverting input terminal connected to the Lo-side source terminal Lc and an inverting input terminal connected to the Lo-side sense terminal Lp through the ground G2, and outputs, with a defined gain, the voltage difference between the voltage of the sense terminal Lp and the voltage of the source terminal Lc. Accordingly, the amplification circuit 21c executes an operation similar to that of the amplification circuit 21c in the impedance measuring device 1Aa.

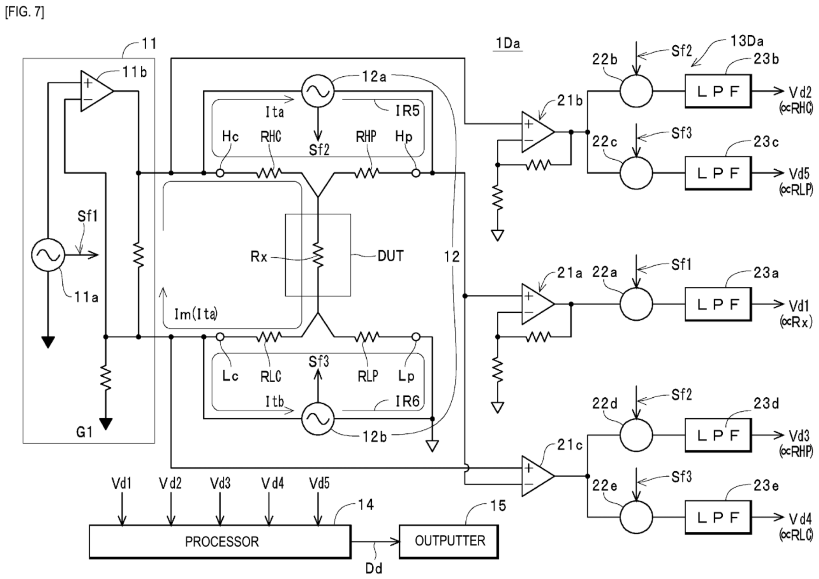

Next, with reference to FIG. 7, for example, the following describes an impedance measuring device 1Da in which the ground G1 of the measurement signal source 11 side in the impedance measuring device 1D and the ground G2 of each component of the impedance measuring device 1D excluding the measurement signal source 11 are different from each other. In the impedance measuring device 1Da, the measurement signal source 11 has a configuration similar to that of the measurement signal source 11 of the impedance measuring device 1Ab, and executes the same operation.

In addition, a detector 13Da may be configured with the amplification circuits 21a and 21b configured as single-ended amplification circuits. In this case, the amplification circuit 21a has a configuration similar to that of the amplification circuit 21a of the impedance measuring device 1Ab, and executes the same operation. In addition, the amplification circuit 21b is provided with a non-inverting input terminal connected to the Hi-side source terminal Hc and an inverting input terminal connected to the Lo-side sense terminal Lp through the ground G2, and outputs, with a defined gain, the voltage difference between the voltage of the sense terminal Lp and the voltage of the source terminal Hc. Accordingly, the amplification circuit 21b executes an operation similar to that of the amplification circuit 21b in the impedance measuring device 1D. Note that in the impedance measuring device 1Da, the amplification circuit 21a may be composed of a differential amplifier circuit with a non-inverting input terminal connected to the Hi-side sense terminal Hp and an inverting input terminal connected to the Lo-side sense terminal Lp. Accordingly, the amplification circuit 21a in this configuration also executes an operation similar to that of the amplification circuit 21a in the impedance measuring device 1D.

In addition, while an example of an impedance measuring device has been described in which, as a detection signal source, the detection signal source 12 is composed of the first detection signal generation circuit 12a that supplies the detection current Ita of AC current and the second detection signal generation circuit 12b that supplies a detection current Itb of AC current, this is not limitative, and it is possible to employ a signal output detection signal source in which either the first detection signal generation circuit 12a or the second detection signal generation circuit 12b outputs a DC inspection signal. For example, in the impedance measuring devices 1A, 1Aa and 1B, it is also possible to employ a configuration in which a DC signal is supplied to the second current paths IR2 and IR4 as an inspection current instead of the detection current Itb output from the second detection signal generation circuit 12b. In this configuration, the arrangement of the synchronous detection circuit 22c may be omitted, and the output signal of the amplification circuit 21b may be directly passed through the low-pass filter 23c to serve as the third detection voltage Vd3. In addition, the arrangement of the synchronous detection circuit 22e may be omitted, and the output signal of the amplification circuit 21c may be directly passed through the low-pass filter 23e to serve as the fifth detection voltage Vd5. In addition, in a configuration in which the supply timings of the first detection current and the second detection current are shifted from each other, both the first detection signal generation circuit 12a and the second detection signal generation circuit 12b may be configured to output a DC inspection signal.

In addition, in the above-described examples, the detection voltages Vd1 to Vd5 are detected by an analog method, and the processor 14 calculates the impedance of the internal resistance Rx (in this example, the resistance value VRx) and each path impedance (in this example, the resistance values VRHC, VRHP, VRLC and VRLP of the contact resistances RHC, RHP, RLC and RLP) based on the detected detection voltages Vd1 to Vd5, but this is not limitative. For example, it is also possible to employ a configuration in which the output signals of the amplification circuits 21a, 21b and 21c are input to an analog/digital convertor provided inside the processor 14, and the processor 14 (a programable integrated circuit such as a CPU and an FPGA provided inside) executes the functions of the synchronous detection circuits 22a to 22e and the low-pass filters 23a to 23e through digital processing. In addition, it is also possible to employ a configuration in which the processor 14 executes the functions of the amplification circuits 21a, 21b and 21c through digital processing.

In addition, while an example has been described in which the resistance value VRx of the internal resistance Rx is measured using the four-terminal method with a battery as the measurement target DUT, it is broadly applicable to measurement devices and measurement methods for measuring voltage, current, power values, and the like of various measurement targets DUTs using the four-terminal method with four probes or connectors connected to connection target portions. In addition, while the impedance measuring devices 1A, 1Aa, 1B, 1C 1D, 1Ab and 1Da calculate the impedance of the internal resistance Rx (in the above-described examples, the resistance value VRx) and the impedances of the contact resistances RHC, RHP, RLC and RLP (in the above-described examples, the resistance values VRHC, VRHP, VRLC and VRLP), it goes without saying that the configuration is also applicable to a configuration of calculating only the real part of the resistance value is to be calculated.

### INDUSTRIAL APPLICABILITY

According to the present invention, the path impedance indicating the connection state of each of the Hi-side source terminal, the Hi-side sense terminal, the Lo-side source terminal and the Lo-side sense terminal with respect to the measurement target during four-terminal measurement can be individually and correctly calculated. In this manner, the present invention can be widely applied to impedance measuring devices and impedance measuring methods for such impedance measurement.

### REFERENCE SIGNS LIST

1A, 1Aa, 1Ab, 1B, 1C, 1D, 1Da Impedance measuring device
11 Measurement signal source
12 Detection signal source
12a First detection signal generation circuit
12b Second detection signal generation circuit
13A, 13Aa, 13Ab, 13B, 13C, 13D, 13Da Detector
14 Processor
21a to 21c Amplification circuit
22a to 22e Synchronous detection circuit
DUT Measurement target
Hc, Lc Source terminal
Hp, Lp Sense terminal
Im AC Measurement current
Ita, Itb Detection current
RHC, RLC, RHP, RLP Contact resistance
Rx Internal resistance
Vd1 First detection voltage
Vd2 Second detection voltage
Vd3 Third detection voltage
Vd4 Fourth detection voltage
Vd5 Fifth detection voltage
VRHC, VRLC, VRHP, VRLP, VRx Resistance value

## Claims

1. An impedance measuring device comprising:
a measurement signal source configured to supply an AC measurement current to a measurement target, with one end connected to a Hi-side source terminal and a Hi-side sense terminal and the other end connected to a Lo-side source terminal and a Lo-side sense terminal, through each of the source terminals;
a detection signal source configured to supply a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target;
a detector configured to detect, through each of the sense terminals, an AC voltage generated between the one end of the measurement target and the other end of the measurement target due to supply of the AC measurement current, and detect, as a detection voltage, each voltage generated at each of the paths due to supply of the detection current; and
a processor configured to calculate an impedance of the measurement target based on a voltage value of the AC voltage detected by the detector and a current value of the AC measurement current, and calculate each of the path impedances based on each of the detection voltages detected by the detector, wherein
the detection signal source is configured to supply a first detection current serving as the detection current to a first current path that includes the Hi-side source terminal, the measurement target, and one of the Lo-side source terminal and the Lo-side sense terminal, and supply a second detection current serving as the detection current to a second current path that includes the Hi-side sense terminal, the measurement target, and the other of the Lo-side source terminal and the Lo-side sense terminal,
the detector detects, as the detection voltage, a voltage generated between the Hi-side source terminal and the Hi-side sense terminal and a voltage generated between the Lo-side source terminal and the Lo-side sense terminal during supply of the first detection current and the second detection current, and
the processor calculates each of the path impedances based on each of the detection voltages detected by the detector.

2. An impedance measuring device comprising:
a measurement signal source configured to supply an AC measurement current to a measurement target, with one end connected to a Hi-side source terminal and a Hi-side sense terminal and the other end connected to a Lo-side source terminal and a Lo-side sense terminal, through each of the source terminals;
a detection signal source configured to supply a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target;
a detector configured to detect, through each of the sense terminals, an AC voltage generated between the one end of the measurement target and the other end of the measurement target due to supply of the AC measurement current, and detect, as a detection voltage, each voltage generated at each of the paths due to supply of the detection current; and
a processor configured to calculate an impedance of the measurement target based on a voltage value of the AC voltage detected by the detector and a current value of the AC measurement current, and calculate each of the path impedances based on each of the detection voltages detected by the detector, wherein
the detection signal source is configured to supply a first detection current serving as the detection current to a first current path that includes the Hi-side source terminal and the Hi-side sense terminal but does not include the measurement target, and supply a second detection current serving as the detection current to a second current path that includes the Lo-side source terminal and the Lo-side sense terminal but does not include the measurement target,
the detector detects, as the detection voltage, a voltage generated between the Hi-side source terminal and one of the Lo-side source terminal and the Lo-side sense terminal and a voltage generated between the Hi-side sense terminal and the other of the Lo-side source terminal and the Lo-side sense terminal during supply of the first detection current and the second detection current, and
the processor calculates each of the path impedances based on each of the detection voltages detected by the detector.

3. The impedance measuring device according to claim 1, wherein
the detection signal source supplies the first detection current and the second detection current of AC current,
the detector includes a detection section configured to perform synchronous detection of each voltage generated between each of the terminals with a synchronization signal having the same frequency as a frequency of each of the detection currents, and detect the voltage as each of the detection voltages, and
the processor calculates each of the path impedances based on each of the detection voltages detected by the detection section.

4. The impedance measuring device according to claim 2, wherein
the detection signal source supplies the first detection current and the second detection current of AC current,
the detector includes a detection section configured to perform synchronous detection of each voltage generated between each of the terminals with a synchronization signal having the same frequency as a frequency of each of the detection currents, and detect the voltage as each of the detection voltages, and
the processor calculates each of the path impedances based on each of the detection voltages detected by the detection section.

5. The impedance measuring device according to claim 3, wherein
the detection signal source is configured to supply the first detection current to a current path including the Hi-side source terminal, the measurement target and the Lo-side source terminal as the first current path, and supply the second detection current to a current path including the Hi-side sense terminal, the measurement target and the Lo-side sense terminal as the second current path,
the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Hi-side sense terminal with a synchronization signal having the same frequency as a frequency of the first detection current, a third synchronous detection circuit configured to generate a third detection signal serving as the detection voltage by synchronously detecting the voltage generated between the Hi-side source terminal and the Hi-side sense terminal with a synchronization signal having the same frequency as a frequency of the second detection current, a fourth synchronous detection circuit configured to generate a fourth detection signal serving as the detection voltage by synchronously detecting the voltage generated between the Lo-side source terminal and the Lo-side sense terminal with the synchronization signal having the same frequency as the frequency of the first detection current, and a fifth synchronous detection circuit configured to generate a fifth detection signal serving as the detection voltage by synchronously detecting the voltage generated between the Lo-side source terminal and the Lo-side sense terminal with the synchronization signal having the same frequency as the frequency of the second detection current, and
the processor calculates the impedance of the measurement target by using a voltage value of the first detection signal as the voltage value of the AC voltage detected by the detector, and calculates each of the path impedances based on the second detection signal, the third detection signal, the fourth detection signal, and the fifth detection signal.

6. The impedance measuring device according to claim 3, wherein
the detection signal source is configured to supply the first detection current to a current path including the Hi-side source terminal, the measurement target and the Lo-side sense terminal as the first current path, and supply the second detection current to a current path including the Hi-side sense terminal, the measurement target and the Lo-side source terminal as the second current path,
the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Hi-side sense terminal with a synchronization signal having the same frequency as a frequency of the first detection current, a third synchronous detection circuit configured to generate a third detection signal serving as the detection voltage by synchronously detecting the voltage generated between the Hi-side source terminal and the Hi-side sense terminal with a synchronization signal having the same frequency as a frequency of the second detection current, a fourth synchronous detection circuit configured to generate a fourth detection signal serving as the detection voltage by synchronously detecting the voltage generated between the Lo-side source terminal and the Lo-side sense terminal with the synchronization signal having the same frequency as the frequency of the second detection current, and a fifth synchronous detection circuit configured to generate a fifth detection signal serving as the detection voltage by synchronously detecting the voltage generated between the Lo-side source terminal and the Lo-side sense terminal with the synchronization signal having the same frequency as the frequency of the first detection current, and
the processor calculates the impedance of the measurement target by using a voltage value of the first detection signal as the voltage value of the AC voltage detected by the detector, and calculates each of the path impedances based on the second detection signal, the third detection signal, the fourth detection signal, and the fifth detection signal.

7. The impedance measuring device according to claim 4, wherein
the detector detects, as the detection voltage, a voltage generated between the Hi-side source terminal and the Lo-side source terminal, and a voltage generated between the Hi-side sense terminal and the Lo-side sense terminal during supply of the first detection current and the second detection current,
the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Lo-side source terminal with a synchronization signal having the same frequency as a frequency of the first detection current, a third synchronous detection circuit configured to generate a third detection signal serving as the detection voltage by synchronously detecting the voltage generated between the Hi-side sense terminal and the Lo-side sense terminal with the synchronization signal having the same frequency as the frequency of the first detection current, a fourth synchronous detection circuit configured to generate a fourth detection signal serving as the detection voltage by synchronously detecting the voltage generated between the Hi-side source terminal and the Lo-side source terminal with a synchronization signal having the same frequency as a frequency of the second detection current, and a fifth synchronous detection circuit configured to generate a fifth detection signal serving as the detection voltage by synchronously detecting the voltage generated between the Hi-side sense terminal and the Lo-side sense terminal with the synchronization signal having the same frequency as the frequency of the second detection current, and
the processor calculates the impedance of the measurement target by using a voltage value of the first detection signal as the voltage value of the AC voltage detected by the detector, and calculates each of the path impedances based on the second detection signal, the third detection signal, the fourth detection signal, and the fifth detection signal.

8. The impedance measuring device according to claim 4, wherein
the detector detects, as the detection voltage, a voltage generated between the Hi-side source terminal and the Lo-side sense terminal, and a voltage generated between the Hi-side sense terminal and the Lo-side source terminal during supply of the first detection current and the second detection current,
the detection section includes a first synchronous detection circuit configured to generate a first detection signal by synchronously detecting the AC voltage generated between the Hi-side sense terminal and the Lo-side sense terminal with a synchronization signal having the same frequency as a frequency of the AC measurement current, a second synchronous detection circuit configured to generate a second detection signal serving as the detection voltage by synchronously detecting the voltage generated between the Hi-side source terminal and the Lo-side sense terminal with a synchronization signal having the same frequency as a frequency of the first detection current, a third synchronous detection circuit configured to generate a third detection signal serving as the detection voltage by synchronously detecting the voltage generated between the Hi-side sense terminal and the Lo-side source terminal with the synchronization signal having the same frequency as the frequency of the first detection current, a fourth synchronous detection circuit configured to generate a fourth detection signal serving as the detection voltage by synchronously detecting the voltage generated between the Hi-side sense terminal and the Lo-side source terminal with a synchronization signal having the same frequency as a frequency of the second detection current, and a fifth synchronous detection circuit configured to generate a fifth detection signal serving as the detection voltage by synchronously detecting the voltage generated between the Hi-side source terminal and the Lo-side sense terminal with the synchronization signal having the same frequency as the frequency of the second detection current, and
the processor calculates the impedance of the measurement target by using a voltage value of the first detection signal as the voltage value of the AC voltage detected by the detector, and calculates each of the path impedances based on the second detection signal, the third detection signal, the fourth detection signal, and the fifth detection signal.

9. The impedance measuring device according to claim 5, wherein the measurement signal source operates also as the detection signal source and supplies the first detection current.

10. The impedance measuring device according to any one of claims 3 to 9, wherein the frequency of the first detection current and the frequency of the second detection current are defined as values different from each other.

11. The impedance measuring device according to any one of claims 3 to 9, wherein the frequency of the AC measurement current, the frequency of the first detection current, and the frequency of the second detection current are defined as values different from each other.

12. An impedance measuring method comprising:
supplying an AC measurement current to a measurement target, with one end connected to a Hi-side source terminal and a Hi-side sense terminal and the other end connected to a Lo-side source terminal and a Lo-side sense terminal, through each of the source terminals;
detecting, through each of the sense terminals, an AC voltage generated between the one end of the measurement target and the other end of the measurement target due to supply of the AC measurement current;
supplying a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target;
detecting, as a detection voltage, each voltage generated at each of the paths due to supply of the detection current; and
measuring an impedance of the measurement target based on a voltage value of the AC voltage detected and a current value of the AC measurement current and measuring each of the path impedances based on each of the detection voltages detected, wherein
a first detection current serving as the detection current is supplied to a first current path that includes the Hi-side source terminal, the measurement target, and one of the Lo-side source terminal and the Lo-side sense terminal, and a second detection current serving as the detection current is supplied to a second current path that includes the Hi-side sense terminal, the measurement target, and the other of the Lo-side source terminal and the Lo-side sense terminal,
a voltage generated between the Hi-side source terminal and the Hi-side sense terminal and a voltage generated between the Lo-side source terminal and the Lo-side sense terminal during supply of the first detection current and the second detection current are detected as the detection voltage, and
each of the path impedances is measured based on each of the detection voltages detected.

13. An impedance measuring method comprising:
supplying an AC measurement current to a measurement target, with one end connected to a Hi-side source terminal and a Hi-side sense terminal and the other end connected to a Lo-side source terminal and a Lo-side sense terminal, through each of the source terminals;
detecting, through each of the sense terminals, an AC voltage generated between the one end of the measurement target and the other end of the measurement target due to supply of the AC measurement current;
supplying a detection current for detecting a path impedance of a path between the Hi-side source terminal and the one end of the measurement target, a path impedance of a path between the Lo-side source terminal and the other end of the measurement target, a path impedance of a path between the Hi-side sense terminal and the one end of the measurement target, and a path impedance of a path between the Lo-side sense terminal and the other end of the measurement target;
detecting, as a detection voltage, each voltage generated at each of the paths due to supply of the detection current; and
measuring an impedance of the measurement target based on a voltage value of the AC voltage detected and a current value of the AC measurement current and measuring each of the path impedances based on each of the detection voltages detected, wherein
a first detection current serving as the detection current is supplied to a first current path that includes the Hi-side source terminal and the Hi-side sense terminal but does not include the measurement target, and a second detection current serving as the detection current is supplied to a second current path that includes the Lo-side source terminal and the Lo-side sense terminal but does not include the measurement target,
a voltage generated between the Hi-side source terminal and one of the Lo-side source terminal and the Lo-side sense terminal and a voltage generated between the Hi-side sense terminal and the other of the Lo-side source terminal and the Lo-side sense terminal during supply of the first detection current and the second detection current are detected as the detection voltage, and
each of the path impedances is measured based on each of the detection voltages detected.
